(19) Europäisches Patentamt / European Patent Office / Office européen des brevets

(11) **EP 3 544 135 B1**

(12) **EUROPEAN PATENT SPECIFICATION**

(45) Date of publication and mention
of the grant of the patent:
**28.06.2023 Bulletin 2023/26**

(21) Application number: **19164068.9**

(22) Date of filing: **20.03.2019**

(51) International Patent Classification (IPC):
*H02H 3/33* (2006.01)   *G01R 31/08* (2020.01)
*H02H 3/347* (2006.01)

(52) Cooperative Patent Classification (CPC):
**H02H 3/334; G01R 31/086; H02H 3/347**

(54) **METHOD AND DEVICE FOR DETERMINING A FAULTY LINE IN A POWER SYSTEM COMPENSATION GRID**

VERFAHREN UND VORRICHTUNG ZUM BESTIMMEN EINER FEHLERHAFTEN LEITUNG IN EINEM KOMPENSATIONSNETZ EINES LEISTUNGSSYSTEMS

PROCÉDÉ ET DISPOSITIF POUR DÉTERMINER UNE LIGNE DÉFECTUEUSE DANS UN RÉSEAU DE COMPENSATION DE SYSTÈME D'ALIMENTATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.03.2018 CN 201810237112**

(43) Date of publication of application:
**25.09.2019 Bulletin 2019/39**

(73) Proprietor: **Siemens Aktiengesellschaft**
**80333 München (DE)**

(72) Inventors:
• **DENG, Xi Zhi**
**NanJing, Jiangsu 211100 (CN)**
• **LIAN, Hai Tao**
**Nanjing, Jiangsu 211100 (CN)**
• **CHEN, Xiao Xiang**
**Nanjing, Jiangsu 210000 (CN)**
• **GUO, Jin Ning**
**Nanjing, Jiangsu 210000 (CN)**
• **WANG, Long Tian**
**Nanjing, Jiangsu 211100 (CN)**

(74) Representative: **Patentanwaltskanzlei WILHELM & BECK**
**Prinzenstraße 13**
**80639 München (DE)**

(56) References cited:
**EP-A1- 1 669 767     WO-A1-2017/200469**
**DE-A1- 4 413 649**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Cross-reference to related application

This application claims the priority of Chinese Patent Application CN 201810237112.7, filed March 21, 2018.

Technical Field

The present application generally relates to the field of a power system compensation grid, and in particular relates to a method and a device for determining a faulty line in a power system compensation grid. In particular the invention relates to method for determining a faulty line in a power system compensation grid according to claim 1 and a corresponding device according to claim 5. Preferred embodiments of the invention are defined by the dependent claims.

Background Art

A power system compensation grid refers to a power system grid whose neutral point is not directly grounded. For example, the neutral point is grounded through an extinction coil or a high-impedance cable. The power system compensation grid is also known as a low current grounding system. The power system compensation grid usually comprises a plurality of lines connected to a busbar and is connected to loads through the lines.

When the power system compensation grid works, a grounding fault, for example, a static grounding fault, may happen to the lines connected to the busbar. In this case, it is necessary to determine the lines to which a grounding fault happens so that workers can perform related operations to overhaul the faulty lines. Thus, how to determine the lines to which a grounding fault happens becomes a problem to be solved urgently.

An example in the prior art is publication WO 2017/200469 A1 that discloses a means for locating earth faults in a multiphase power grid.

Summary of the Invention

In view of the above-mentioned problem, the present application provides a method and a device for determining a faulty line in a power system compensation grid.

According to one aspect of the present application, a method for determining a faulty line in a power system compensation grid is provided. Said power system compensation grid comprises a plurality of lines connected to a busbar. Detection currents are periodically generated on each line of said plurality of lines based on pulsed clock signals if a grounding fault happens in said power system compensation grid. Said method comprises: acquiring detection currents on a line to be detected in said power system compensation grid, determining the number of characteristic waveform patterns contained in the waveforms of said detection currents in a preset range based on the change rate of said detection currents, wherein said characteristic waveform pattern is a waveform pattern reversely matching the one-period signal waveform of said pulsed clock signals, and determining that said line to be detected is a faulty line if the number of characteristic waveform patterns is greater than or equal to a preset threshold.

With this method, by detecting the number of characteristic waveform patterns contained in the waveforms of the detection currents in the preset range based on the change rate of the detection currents and determining whether the line to be detected is faulty based on the number of the detected characteristic waveform patterns, the reliability of the faulty line detection can be improved greatly.

Alternatively, in one example of the above-mentioned aspect, said compensation grid further comprises an extinction coil, a capacitor connected in parallel with said extinction coil and a transformer connected with said busbar, said extinction coil is connected with the neutral point of said transformer, and periodically generating detection currents on each line of said plurality of lines based on pulsed clock signals specifically comprises: using said pulsed clock signals to periodically enable/disable said capacitor to periodically generate detection currents on each line of said plurality of lines.

Alternatively, in one example of the above-mentioned aspect, the enabling duration of said capacitor is not equal to the disabling duration of said capacitor.

Alternatively, in one example of the above-mentioned aspect, determining the number of characteristic waveform patterns contained in the waveforms of said detection currents in a preset range based on the change rate of said detection currents comprises: determining each current jump point in the waveforms of the detection currents in said preset range, determining the corresponding steady-state current at each current jump point, and determining the number of characteristic waveform patterns contained in the waveforms of said detection currents in said preset range based on the change rate of the corresponding steady-state current at each current jump point relative to the corresponding steady-state current at the previous current jump point.

Alternatively, in one example of the above-mentioned aspect, determining the number of characteristic waveform patterns contained in the waveforms of said detection currents in said preset range based on the change rate of the corresponding steady-state current at each current jump point relative to the corresponding steady-state current at the previous current jump point comprises: determining the rising edge current jump points and the falling edge current jump points in said current jump points based on the change rate of the corresponding stead-state current at each current jump point relative to the corresponding steady-state current at the previous current jump point, wherein said rising edge current jump point represents a current jump point at which the waveform of said detection current changes from a steady state or falling state to a rising state, and said falling edge current jump point represents a current jump point at which the waveform of said detection current changes from a steady state or rising state to a falling state, for each rising edge current jump point, acquiring the time intervals between said current jump point and the two adjacent falling edge current jump points, and determining the number of characteristic waveform patterns contained in the waveforms of the detection currents in said preset range based on the acquired corresponding two time intervals of each rising edge current jump point and the enabling duration and disabling duration of said capacitor.

Alternatively, in one example of the above-mentioned aspect, determining the number of characteristic waveform patterns contained in the waveforms of said detection currents in said preset range can further comprise selecting rising edge current jump points whose two adjacent current jump points are both falling edge current jump points from the determined rising edge current jump points after determining the rising edge current jump points in said current jump points but before acquiring the time intervals between said current jump point and the two adjacent falling edge current jump points for each selected rising edge current jump point. Thus, it can be determined that said rising edge current jump point is the real rising edge current jump point of a zero-current current.

Alternatively, in one example of the above-mentioned aspect, determining each current jump point in the waveforms of the detection currents in said preset range comprises determining a current point satisfying the following two conditions in the waveforms of said detection currents to be a current jump point: $\dfrac{\left|I\left(t\right) - I\left(t - T\right)\right|}{\left|I\left(t\right) - I\left(t - 2T\right)\right|} > K1$ and $|I(t) - I(t - T)| > k2 * \max\{I(t), I(t - T)\}$, wherein, t is the time on the waveform of the corresponding detection current at said current point, T is the sampling period of said detection current, $I(t)$, $I(t - T)$ and $I(t - 21)$ are respectively the corresponding current values at t, t-T and t-2T, K1 is a first preset threshold, K2 is a second preset threshold, K1 is greater than 1 and K2 is less than 1.

Alternatively, in one example of the above-mentioned aspect, determining the corresponding steady-state current at each current jump point comprises determining the corresponding steady-state current at said current jump point according to the corresponding current values at said plurality of consecutive current points when a plurality of consecutive current points satisfying the following condition exist in the waveforms of the detection currents between said current jump point and the previous current jump point and the duration is greater than or equal to a third preset threshold: $|I(t) - I(t - T)| < k2 * \max\{I(t), I(t - T)\}$.

Alternatively, in one example of the above-mentioned aspect, determining the corresponding steady-state current at said current jump point according to the corresponding current values at said plurality of consecutive current points comprises determining the corresponding current at the first current point of said plurality of consecutive current points to be the corresponding steady-state current at said current jump point.

Alternatively, in one example of the above-mentioned aspect, determining the number of characteristic waveform patterns contained in the waveforms of the detection currents in said preset range based on the acquired corresponding two time intervals of each rising edge current jump point and the enabling duration and disabling duration of said capacitor comprises: for each rising edge current jump point, acquiring the absolute value of the difference between the enabling duration of said capacitor and the time interval between said rising edge current jump point and the previous current jump point to obtain a first difference, acquiring the absolute value of the difference between the disabling duration of said capacitor and the time interval between said rising edge current jump point and the next current jump point to obtain a second difference, and if said first difference and said second difference are both less than or equal to a preset threshold, determining that a characteristic waveform pattern corresponding to said rising edge current jump point exists, and counting the determined characteristic waveform patterns as the number of characteristic waveform patterns contained in the waveforms of detection currents in said preset range.

According to another aspect of the present application, a device for determining a faulty line in a power system compensation grid is provided. Said power system compensation grid comprises a plurality of lines connected to a busbar. Detection currents are periodically generated on each line of said plurality of lines based on pulsed clock signals if a grounding fault happens in said power system compensation grid. Said device comprises an acquiring unit configured to acquire detection currents on a line to be detected in said power system compensation grid, a characteristic waveform pattern number determining unit configured to determine the number of characteristic waveform patterns contained in the waveforms of said detection currents in a preset range based on the change rate of said detection currents, wherein said characteristic waveform pattern is a waveform pattern reversely matching the one-period signal waveform of said pulsed clock signals, and a faulty line determining unit configured to determine that said line to be detected is a faulty line if the number of characteristic waveform patterns is greater than or equal to a preset threshold.

With the device in the present application, by detecting the number of characteristic waveform patterns contained in the waveforms of the detection currents in the preset range based on the change rate of the detection currents and determining whether the line to be detected is faulty based on the number of the detected characteristic waveform patterns, the reliability of the faulty line detection can be improved greatly.

Alternatively, in an example of the above-mentioned aspect, said power system compensation grid further comprises an extinction coil, a capacitor connected in parallel with said extinction coil and a transformer connected with said busbar, said extinction coil is connected with the neutral point of said transformer, and said periodical generation of detection currents on each line of said plurality of lines is realized on each line by using said pulsed clock signals to periodically enable/disable said capacitor.

Alternatively, in one example of the above-mentioned aspect, the enabling duration of said capacitor is not equal to the disabling duration of said capacitor.

Alternatively, in one example of the above-mentioned aspect, said characteristic waveform pattern number determining unit can comprise a current jump point determining module configured to determine each current jump point in the waveforms of detection currents in said preset range, a steady-state current determining module configured to determine the corresponding steady-state current at each current jump point, and a characteristic waveform pattern number determining module configured to determine the number of characteristic waveform patterns contained in the waveforms of said detection currents in said preset range based on the change rate of the corresponding steady-state current at each current jump point relative to the corresponding steady-state current at the previous current jump point.

Alternatively, in one example of the above-mentioned aspect, said characteristic waveform pattern number determining module can comprise a rising edge/falling edge current jump point determining submodule configured to determine the rising edge current jump points and the falling edge current jump points in said current jump points based on the change rate of the corresponding stead-state current at each current jump point relative to the corresponding steady-state current at the previous current jump point, wherein said rising edge current jump point represents a current jump point at which the waveform of said detection current changes from a steady state or falling state to a rising state, and said falling edge current jump point represents a current jump point at which the waveform of said detection current changes from a steady state or rising state to a falling state, a time interval acquiring submodule configured to acquire the time intervals between said current jump point and the two adjacent falling edge current jump points for each selected rising edge current jump point, and a characteristic waveform pattern number determining submodule configured to determine the number of characteristic waveform patterns contained in the waveforms of the detection currents in said preset range based on the acquired corresponding two time intervals of each rising edge current jump point and the enabling duration and disabling duration of said capacitor.

Alternatively, in one example of the above-mentioned aspect, said characteristic waveform pattern number determining module can further comprise a selecting submodule configured to select rising edge current jump points whose two adjacent current jump points are both falling edge current jump points from the determined rising edge current jump points.

Alternatively, in one example of the above-mentioned aspect, said current jump point determining module is configured to determine a current point satisfying the following two conditions in the waveforms of said detection currents to be a current jump point: $\dfrac{\left|I(t) - I(t - T)\right|}{\left|I(t) - I(t - 2T)\right|} > K1$ and $|I(t) - I(t - T)| > k2 * \max\{I(t), I(t - T)\}$, wherein, t is the time on the waveform of the corresponding detection current at said current point, T is the sampling period of said detection current, I(t), I(t - T) and I(t - 2T) are respectively the corresponding current values at t, t - T and t - 2T, K1 is a first preset threshold, K2 is a second preset threshold, K1 is greater than 1 and K2 is less than 1.

Alternatively, in one example of the above-mentioned aspect, said steady-state current determining module is configured to determine the corresponding steady-state current at said current jump point according to the corresponding current values at said plurality of consecutive current points when a plurality of consecutive current points satisfying the following condition exist in the waveforms of the detection currents between said current jump point and the previous current jump point and the duration is greater than or equal to a third preset threshold:

$$\left|I(t) - I(t - T)\right| < k2 * \max\{I(t), I(t - T)\}.$$

Alternatively, in one example of the above-mentioned aspect, said steady-state current determining module is configured to determine the corresponding current at the first current point of said plurality of consecutive current points to be the corresponding steady-state current at said current jump point.

Alternatively, in one example of the above-mentioned aspect, said characteristic waveform pattern number determining submodule is configured to acquire for each rising edge current jump point the absolute value of the difference between the enabling duration of said capacitor and the time interval between said rising edge current jump point and the previous current jump point to obtain a first difference, acquire the absolute value of the difference between the disabling duration of said capacitor and the time interval between said rising edge current jump point and the next current jump point to obtain a second difference, and if said first difference and said second difference are both less than or equal to a preset threshold, determine that a characteristic waveform pattern corresponding to said rising edge current jump point exists, and count the determined characteristic waveform patterns as the number of characteristic waveform patterns contained in the waveforms of detection currents in said preset range.

According to a further aspect of the present application, a computing device is provided, which comprises processors and a memory coupled with said processors and configured to store instructions, wherein when said instructions are executed by said one or more processors, said processors will execute the above-mentioned method for determining a faulty line in a power system compensation grid.

According to a fourth aspect of the present application, a machine readable storage medium is provided, which stores executable instructions, wherein when said instructions are executed, said machine will execute the above-mentioned method for determining a faulty line in a power system compensation grid.

Brief Description of the Drawings

The essence and advantages of the present disclosure can further be understood by reference to the drawings. In the drawings, similar components or characteristics can have the same reference numerals.

Fig. 1 shows the structure of a power system compensation grid.

Fig. 2 shows the waveform of a pulsed control signal of pulse clock equipment and the current waveforms of detection currents on a non-faulty line 7-1 and a faulty line 7-3 during periodical enabling/disabling of the capacitor connected in parallel with the extinction coil.

Fig. 3 shows a block diagram for a system for determining a faulty line in a power system compensation grid according to the present application.

Fig. 4 shows a block diagram for a device for determining a faulty line in a power system compensation grid according to the present application.

Fig. 5 shows a block diagram for a specific implementation example of the characteristic waveform pattern number determining unit in Fig. 4.

Fig. 6 shows a block diagram for a specific implementation example of the characteristic waveform pattern number determining module in Fig. 5.

Fig. 7 shows a flowchart of the method for determining a faulty line in a power system compensation grid according to the present application.

Fig. 8 shows a flowchart of an implementation example of the procedure of the determination of the number of characteristic waveform patterns contained in the waveforms of detection currents in a preset range based on the change rate of detection currents in Fig. 7.

Fig. 9 shows a flowchart of an implementation example of the procedure of the determination of the number of characteristic waveform patterns contained in the waveforms of detection currents in a preset range based on the change rate of the corresponding steady-state current at each current jump point relative to the corresponding steady-state current at the previous current jump point in Fig. 8.

Fig. 10 shows a flowchart of an implementation example of the procedure of the determination of the number of characteristic waveform patterns contained in the waveforms of the detection currents in a preset range based on the acquired two time intervals of each rising edge current jump point and the enabling duration and disabling duration of said capacitor in Fig. 9.

Fig. 11 shows a block diagram for a computing device for determining a faulty line in a power system compensation grid according to the present application.

Description of reference numerals in the drawings

1. Power source
2. Transformer
3. Zero-sequence voltage detection device

4. Pulse clock equipment
51. Capacitor
52. Extinction coil
60. Switch
6. Busbar
7-1. Line 7-1
7-2. Line 7-2
7-3. Line 7-3
8-1. Load 8-1
8-2. Load 8-2
8-3. Load 8-3
W1. Waveform of pulsed clock signals
W2. Waveform of zero-sequence current on non-faulty line
W3. Waveform of zero-sequence current on faulty line
10. Faulty line determining system
100. Current monitoring device
200. Faulty line determining device
210. Acquiring unit
220. Characteristic waveform pattern number determining unit
230. Faulty line determining unit
221. Current jump point determining module
223. Steady-state current determining module
225. Characteristic waveform pattern number determining module
2251. Rising edge/falling edge current jump point determining submodule
2253. Time interval acquiring submodule
2255. Characteristic waveform pattern number determining submodule
2257. Selecting submodule
710. Acquire detection currents on the monitored line to be detected
730. Determine the number of characteristic waveform patterns contained in the waveforms of detection currents in a preset range based on the change rate of detection currents 750. Determine whether a line to be detected is a faulty line 810. Determine each current jump point in the waveforms of detection currents in said preset range
820. Determine the corresponding steady-state current at each current jump point
830. Determine the number of characteristic waveform patterns contained in the waveforms of detection currents in said preset range based on the change rate of the corresponding steady-state current at each current jump point relative to the corresponding steady-state current at the previous current jump point
910. Determine rising edge current jump points and falling edge current jump points in said current jump points
920. For each rising edge current jump point, acquire the time intervals between said rising edge current jump point and its two adjacent falling edge current jump points
930. Determine the number of characteristic waveform patterns contained in the waveforms of detection currents in said preset range based on the acquired two time intervals of each rising edge current jump point and the enabling duration and disabling duration of said capacitor
1010. Acquire the absolute value of the difference between the enabling duration of said capacitor and the time interval between said rising edge current jump point and the previous current jump point to obtain a first difference
1020. Acquire the absolute value of the difference between the disabling duration of said capacitor and the time interval between said rising edge current jump point and the next current jump point to obtain a second difference
1030. Determine whether the first difference and the second difference are both less than or equal to a preset threshold
1040. Increase the count of characteristic waveform patterns by 1
1050. Is the determination of characteristic waveform patterns for all rising edge current jump points completed?
1100. Computing device
1110. Processor
1120: Memory

## Detailed Description of the Invention

Now, the subjects described in this document are discussed by reference to exemplary embodiments. It should be understood that the discussions about these embodiments are only intended to let those skilled in the art better understand the subjects described in this document, but are not intended to restrict the scope of protection, applicability, or examples described in the claims. Changes can be made to the functions and arrangements of the discussed elements, without departing from the scope of protection of the disclosure. Various processes or components can be omitted, replaced, or added in different examples, as required. For example, the described method can be executed in a sequence different from what is described, and the steps can be added, omitted or combined. In addition, the characteristics described relative to some examples can also be combined in other examples.

As used in this document, the term "comprise" and its variants are open terms and mean "include but are not limited to". The term "based on" means "at least partially based on". The terms "one embodiment" and "one example" means "at least one embodiment". The term "another embodiment" mean "at least one other embodiment". The terms "first" and "second" can refer to different or identical objects. Other definitions, explicit or implicit, can be included below. Unless otherwise specified in the context, the definition of a term is consistent in the whole description.

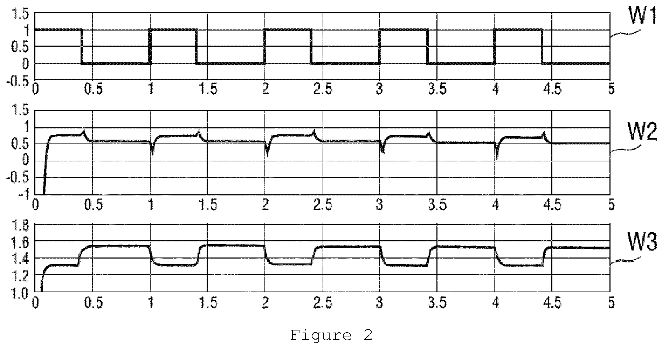

In this document, the term "characteristic waveform pattern" refers to a waveform pattern reversely matching the one-period signal waveform of pulsed clock signals generated by the pulse clock equipment when a grounding fault happens in a power system compensation grid. Said reverse matching means that the waveforms of detection currents are split by period, the waveform part in each period is reversely processed, and then the pattern of the reversely processed waveform part is matched against the pattern of the one-period signal waveform of pulsed clock signals. If successfully matched, the waveform part is considered a characteristic waveform pattern. Otherwise, the waveform part is not considered a characteristic waveform pattern. Reverse processing in the present embodiment can be considered a 180-dgree rotation of the whole waveform from the top down, namely, vertical flip. The horizontal coordinate in Fig. 2 represents the detection time and the longitudinal coordinate represents the current.In the waveform W3 of the detection current on the faulty line in Fig. 2, the waveform part from 0.5s to 1.5s belongs to a characteristic waveform pattern. From Fig. 2, it can be seen that the waveform W3 contains 4 characteristic waveform patterns. Here, a waveform pattern can refer to the change trend of a one-period waveform part of a periodic waveform. For example, the current at 1s starts to tend to rise in the waveform W1, and accordingly, the current at 1s starts to tend to fall at 1s in the waveform W3. The duration of the steady-state current between 1s and 1.5s in the waveform W1 is almost equal to the duration of the steady-state current between 1s and 1.5s in the waveform W3. The match in the present invention means that two waveform patterns are roughly consistent, but are not required to be exactly the same.

In this document, the term "current jump point in a current waveform" refers to a corresponding current point at which the current changes from one state to another state, for example, from a rising state or steady state to a falling state, or from a falling state or steady state to a rising state. There are three states: rising state, steady state and falling state.

In this document, the term "steady current state of the current waveform part" means that the current fluctuates in a preset range and lasts a preset time. The steady current state reflected in the current waveform is close to a straight line. The waveform from 1.5s to 2s in the waveform W3 in Fig. 2 reflects the steady current state. The term "steady-state current" refers to the current in the steady current state. For example, the current is continuously measured for three times, and the current measured for the first time is selected as the steady-state current. Of course, the stead-state current can be determined by use of other methods and these methods will not be described here.

In this document, the term "enabling duration of the capacitor" refers to the duration during which the capacitor connected in parallel with the extinction coil is enabled in a period of pulsed clock signals. The term "disabling duration of the capacitor" refers to the duration during which the capacitor connected in parallel with the extinction coil is disabled in a period of pulsed clock signals.

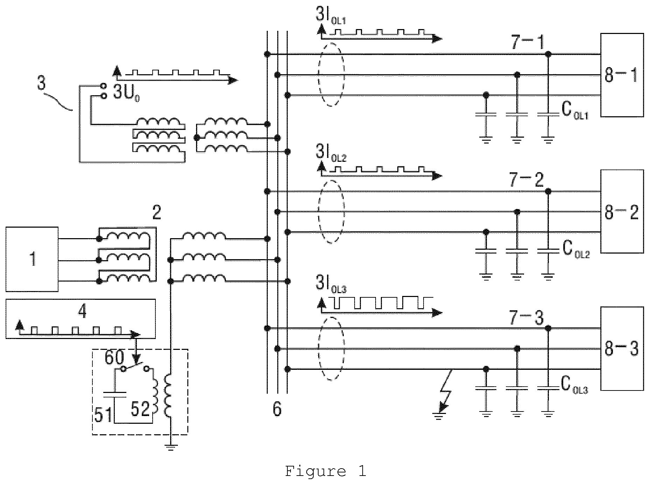

Fig. 1 shows the structure of a power system compensation grid. As shown in Fig. 1, the power system compensation grid comprises a power source 1, a transformer 2 on one side of a busbar 6, a zero-sequence voltage detection device 3, pulse clock equipment 4, a capacitor 51, and an extinction coil 52, a busbar 6, line 7-1, line 7-2, line 7-3, load 8-1, load 8-2, and load 8-3.

The power source 1 provides voltage signals for loads 8-1, 8-2 and 8-3. The transformer 2, connected to the power source 1 and the busbar 6, respectively, is configured to perform voltage transformation for the voltage signal provided by the power source 1 and provide the voltage signal after voltage transformation to the busbar 6. The busbar 6 is connected to the load 8-1 through the line 7-1, the load 8-2 through the line 7-2, and the load 8-3 through the line 7-3. The voltage signal obtained after the voltage transformation of the transformer 2 is provided to the loads 8-1, 8-2 and 8-3 through the lines 7-1, 7-2 and 7-3, respectively.

The zero-sequence voltage detection device 3, connected to the busbar 6, is configured to detect the zero-sequence voltage generated on the busbar 6 when a grounding fault happens in the power system compensation grid (that is to say, when a grounding fault happens to a line of the lines 7-1, 7-2 and 7-3). For example, the zero-sequence voltage detection device 3 can be realized by use of a voltage transformer, as shown in Fig. 1. One side of the voltage transformer, which is connected to the busbar, is the primary side, and the other side which is not connected to the busbar is the secondary side.

The zero-sequence voltage detection device 3, also connected to pulse clock equipment 4 in a wireless or wired way, for example, is configured to trigger the pulse clock equipment 4 to generate a pulsed clock signal when a zero-sequence voltage is detected. That is to say, when a zero-sequence voltage appears on a line, it can be determined that a grounding fault happens to the line. In this case, a zero-sequence current is already accordingly generated on each line. The zero-sequence current is very low, however. Thus, additional pulse clock equipment 4 is required to generate an additional zero-sequence current on each line. After the zero-sequence current resulted from a grounding fault superimposes the zero-sequence current generated by the pulse clock equipment 4, the current on each line is the detection current in the present invention. Alternatively, the low-level duration and the high-level duration in a period of the pulsed clock signal are allowed to be unequal so that a characteristic waveform pattern can be identified more conveniently. As shown in Fig. 2, the waveform of a pulsed control signal is W1, the waveform of a detection current on a non-faulty line is W2, and the waveform of a detection current on a faulty line is W3. The low-level duration and the high-level duration of the pulsed signal on the faulty line are equal.

The extinction coil 52 is connected to the neutral point of the transformer 2, the capacitor 51 is further coupled with or disconnected from the extinction coil 52 through a switch 60, and the current waveform of the detection current on a line to be detected (for example, zero-sequence current $3I_{0L1}$, $3I_{0L2}$ or $3I_{0L3}$ on grounded lines 7-1, 7-2 and 7-3) can be changed by periodically enabling/disabling the capacitor 51 connected in parallel with the extinction coil 52. The closing and opening of the switch is controlled by the pulsed clock signal generated by the pulse clock equipment 4.

Table 1 lists the changes of zero-sequence currents on the non-faulty line 7-1 and the faulty line 7-3 during the enabling and disabling of the capacitor 51 connected in parallel with the extinction coil 52.

| Capacitor status $3I_0$ | Disabled | Enabled |
|---|---|---|
| $3I_0$ on the non-faulty line 1 | $3\omega C_{0L1} U_0$ | $(3\omega C_{0L1} + \omega C_a) U_0$ |
| $3I_0$ on the faulty line 3 | $[\dfrac{1}{\omega L_0} - 3\omega (C_{0\Sigma} - C_{0L3})] U_0$ | $[\dfrac{1}{\omega L_0} - 3\omega (C_{0\Sigma} - C_{0L3}) - \omega C_a] U_0$ |

Table 1

As shown in Table 1, when the capacitor 51 is enabled (that is to say, the switch 60 is closed), the zero-sequence current $3I_{0L1}$ on the non-faulty line 7-1 increases from $3\omega C_{0L1} U_0$ to $(3\omega) C_{0L1} + \omega C_a) U_0$, and the zero-sequence current $3I_{0L3}$ on the faulty line 7-3 decreases from

$$\left[\frac{1}{\omega L_0} - 3\omega (C_{0\Sigma} - C_{0L3})\right] U_0 \quad to \quad \left[\frac{1}{\omega L_0} - 3\omega (C_{0\Sigma} - C_{0L3}) - \omega C_a\right] U_0$$

, wherein $3I_{0Li}$ is the zero-sequence on the line 7-i, $U_0$ is the zero-sequence voltage on the busbar, $C_{0Li}$ is the zero-sequence capacitance on the line 7-i, $L_0$ is the inductance of the extinction coil, Ca is the capacitance of the capacitor 51 connected in parallel with the extinction coil 52, $\omega = 2\pi f$, f is the frequency of the power system compensation grid, $C_{0\Sigma}$ is the total zero-sequence capacitance of the power system compensation grid, $C_{0\Sigma} = \sum_{i=1}^{3} C_{0Li}$, $C_{0Li}$ is the capacitance on the line 7-i, the

capacitance on each line can be obtained through a measurement, and the total zero-sequence capacitance of the power system compensation grid can be obtained by summing the capacitances on all the lines.

Fig. 2 shows the waveform W1 of a pulsed control signal of pulse clock equipment and the current waveforms W2 and W3 of detection currents on the non-faulty line 7-1 and the faulty line 7-3 during periodical enabling/disabling of the capacitor 51. From Fig. 2, it can be seen that the waveform pattern in the waveform W3 of the detection current on the faulty line 7-3 reversely matches the waveform pattern in the waveform W1 of the pulsed clock signal of the pulse clock equipment, that is to say, the waveform pattern obtained after reverse processing of the waveform W3 approximately matches the waveform pattern in the waveform W1, but the waveform pattern in the current waveform W2 of the detection current on the non-faulty line 7-1 does not match the waveform pattern in the waveform W1 of the pulsed clock signal. Thus, by reversely matching the waveforms of the detection currents on the faulty line 7-3 and the non-faulty line 7-1 against the waveform of the pulsed clock signal, the faulty line can be distinguished from the non-faulty line.

In the prior zero-sequence current based faulty line determination schemes, the capacitor 51 connected in parallel with the extinction coil 52 is periodically enabled/disabled to change the current waveform of the detection current (for example, current $3I_{0L1}$, $3I_{0L2}$ or $3I_{0L3}$ on the grounded line 7-1, 7-2 and 7-3) on the line to be detected, and then whether a line to be detected is faulty or not is determined by determining whether the number of characteristic waveform patterns contained in the waveform of a detection current on the line to be detected in a preset range is greater than or equal to a preset threshold.

In the above-mentioned line selection scheme for a grounding fault, when a characteristic waveform pattern is determined, the following comparison procedure is performed for the one-period waveform part of the waveform of the detection current: (1) compare whether the enabling duration (for example, duration of the high-level signal) of the capacitor in the pulsed clock signal and the duration (for example, duration of the low-level signal) of the reverse waveform part in the waveform of the detection current are approximately equal, and compare whether the disabling duration (for example, duration of the low-level signal) of the capacitor in the pulsed clock signal and the duration (for example, duration of the high-level signal) of the reverse waveform part in the waveform of the detection current are approximately equal, or (2) compare the absolute difference between the detection currents respectively corresponding to the capacitor enabling signal and the capacitor disabling signal with a preset current threshold. If the comparison result in comparison procedure (1) shows an approximate equality or the comparison result in comparison procedure (2) shows that the absolute difference is greater than the preset current threshold, the waveform part in the period is a characteristic waveform pattern.

However, when a grounding fault happens in a power system compensation grid, the absolute difference of the zero-sequence current (detection current) on the faulty line varies greatly because both the faulty location and the grounding impedance are uncertain.

Table 2 lists the relationships of different fault locations and grounding impedances with current change differences in a zero-sequence current in a 10-kV grounding system. In table 2, Off refers to the case in which the switch is opened so that the capacitor 51 is disabled, while On refers to the case in which the switch is closed so that the capacitor 51 is enabled. A fault location is denoted by the distance between the fault location and the installation location of a power grid protection device in the power system compensation grid. For example, fault location 1 km refers to a fault location which is 1 km away from the installation location of a power grid protection device.

| Impedance<br>Fault<br>location | | 0 ohm | | | 100 ohm | | | 500 ohm | | | 1000 ohm | | | 5000 ohm | | |
|---|---|---|---|---|---|---|---|---|---|---|---|---|---|---|---|---|
| | | Off | On | $\Delta 3I_0$ | Off | On | $\Delta 3I_0$ | Off | On | $\Delta 3I_0$ | Off | On | $\Delta 3I_0$ | Off | On | $\Delta 3I_0$ |
| 1km | $3I_0$ | 8.39A | 6.68A | 1.71A | 8.05A | 6.41A | 1.64A | 6.91A | 5.52A | 1.39A | 5.86A | 4.70A | 1.16A | 2.58A | 2.13A | 0.45A |
| 10km | $3I_0$ | 8.12A | 6.48A | 1.64A | 7.79A | 6.22A | 1.57A | 6.70A | 5.36A | 1.34A | 5.68A | 4.57A | 1.11A | 2.52A | 2.08A | 0.44A |
| 30km | $3I_0$ | 7.56A | 6.05A | 1.51A | 7.26A | 5.81A | 1.45A | 6.26A | 5.02A | 1.24A | 5.32A | 4.29A | 1.03A | 2.37A | 1.96A | 0.41A |

Table 2

As shown in Table 2, $\Delta 3I_0$ is 1.71 A when the impedance is 0 ohm and the fault location is 1 km, and 0.41 A when the impedance is 5000 ohm and the fault location is 30 km. The currents in Table 2 are all primary currents of the power system, while the detection currents collected for determining a faulty line are secondary currents. The primary currents themselves are not very high and the secondary currents which the primary currents are converted into will become lower. To keep the protection area as large as possible so as to correctly determine a faulty line in the situations of different fault locations and grounding impedances, namely, cover the situations of all fault locations and grounding impedances in Table 2, if only an absolute difference is used for a comparison, then the comparison reference must be a small threshold, for example, less than 0.41 A. However, the secondary value may be only a few milliamperes in this case. For example, when the change rate of the voltage transformer is 100/1, the corresponding secondary value is only 4 milliamperes. In this case, if the current fluctuates because the system suffers electromagnetic interference, it will still be detected that a grounding fault happens to a line to be detected, and thus, the protection device will be triggered to start a protection, for example, a trip. As a result, a protection misoperation, for example, a mistrip is caused.

Now, the embodiments of the method, device and system for determining a faulty line in a power system compensation grid in the present application are described in combination with the drawings.

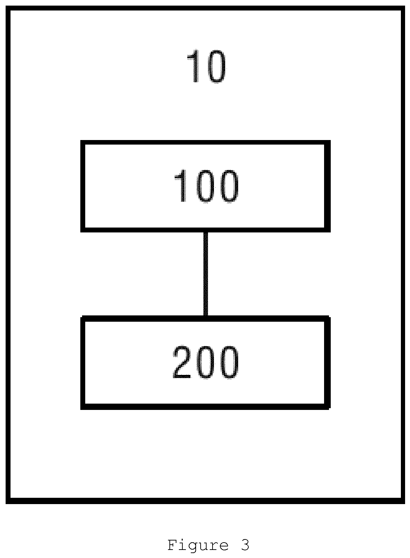

Fig. 3 shows a block diagram for the system 10 (hereinafter referred to as faulty line determining system 10) for determining a faulty line in a power system compensation grid according to the present application.

As shown in Fig. 3, the faulty line determining system 10 comprises a current monitoring device 100. The current monitoring device 100 is configured to monitor the detection currents on each line to be detected. For a power system compensation grid comprising a plurality of lines connected to a busbar 6, when a grounding fault happens in the power system compensation grid, the zero-sequence voltage detection device 3 will detect the zero-sequence voltage on the busbar 6, and then trigger the pulse clock equipment 4 to generate a pulsed clock signal. The pulsed clock signal periodically closes and opens the switch 60 configured to couple the capacitor 51 with the extinction coil 52 or disconnect the capacitor from the extinction coil, thus periodically enabling/disabling the capacitor 51 connected in parallel with the extinction coil 52 to generate a detection current (namely, the sum of the zero-sequence current generated by a pulsed clock signal respectively on the lines 7-1, 7-2 and 7-3 and the zero-sequence current generated when a fault happens) on the lines to be detected (for example, the lines 7-1, 7-2 and 7-3). The current monitoring device 100 can be any type of current-measuring device, for example, a current sensor.

The faulty line determining system 10 further comprises a device 200 for determining a faulty line in a power system compensation grid (hereinafter referred to as faulty line determining device 200). The faulty line determining device 200, coupled with the current monitoring device 100 in a wired or wireless way, is configured to acquire the detection current monitored by the current monitoring device 100 on a line to be detected and determine whether the line to be detected is faulty based on the waveform of the received detection current on the line to be detected.

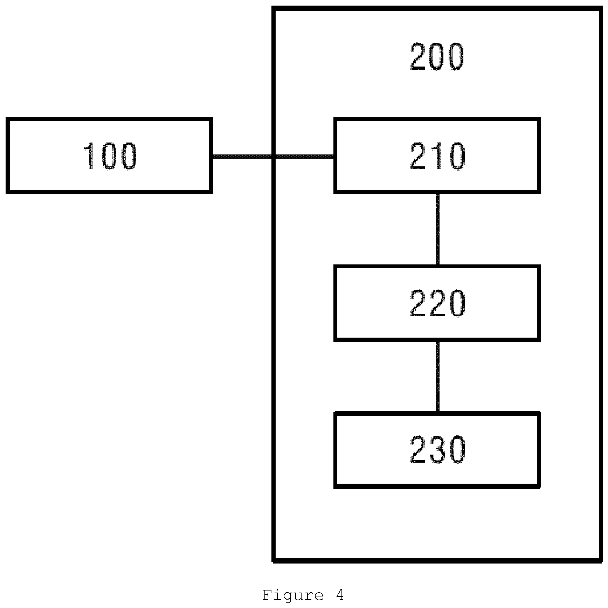

Fig. 4 shows a block diagram for an example of the faulty line determining device 200 according to the present application. As shown in Fig. 4, the faulty line determining device 200 comprises an acquiring unit 210, which is configured to acquire the monitored detection current on the line to be detected from the current monitoring device 100. The acquiring unit 210 can communicate with the current monitoring device 100 in an active acquiring or passive receiving way to acquire the detection current on a line to be detected. The communication between the acquiring unit 210 and the current monitoring device 100 can be wired communication or wireless communication.

The faulty line determining device 200 further comprises a characteristic waveform pattern number determining unit 220, which is configured to determine the number of characteristic waveform patterns contained in the waveforms of said detection currents in a preset range based on the change rate of said detection currents. Here, the preset range can be set arbitrarily or can be set according to a trial value or empirical value. For example, the preset range is 5 pulse periods. If 3 (the number can be set according to the actual requirement) characteristic waveform patterns are successfully matched in this observation range, the line is considered faulty.

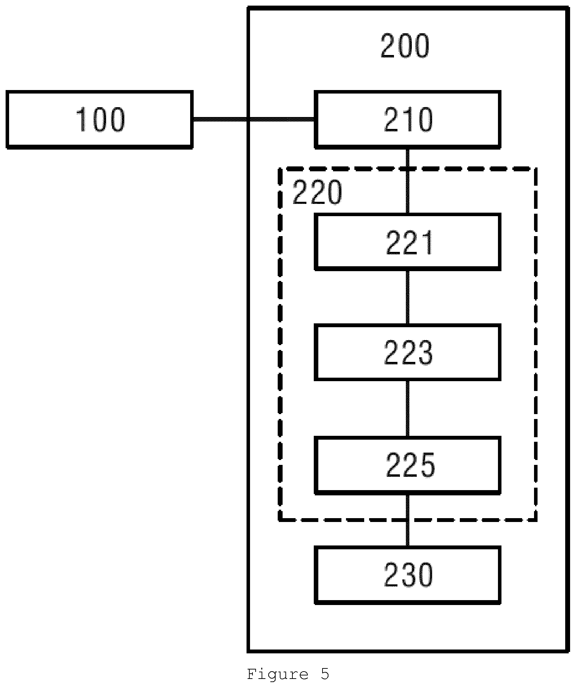

Fig. 5 shows a block diagram for a specific implementation example of the characteristic waveform pattern number determining unit 220 in Fig. 4. As shown in Fig. 5, the characteristic waveform pattern number determining unit 220 can comprise a current jump point determining module 221, a steady-state current determining module 223 and a characteristic waveform pattern number determining module 225.

The current jump point determining module 221 is configured to determine each current jump point in the waveforms of detection currents in the preset range. For example, in one example, the current jump point determining module 221 can determine a current point satisfying the following two conditions in the waveforms of detection currents in the preset range to be a current jump point:

$$(1) \quad \frac{\left| I(t) - I(t-T) \right|}{\left| I(t) - I(t-2T) \right|} > K1$$

and

$$(2) \quad \left| I(t) - I(t-T) \right| > k2 * \max\left\{ I(t), I(t-T) \right\},$$

wherein, t is the time on the waveform of the corresponding detection current at said current point, T is the sampling period of said detection current, I(t) , I (t - T) and I (t - 2T) are respectively the corresponding current values at t, t-T and t-2T, K1 is a first preset threshold, K2 is a second preset threshold, K1 is greater than 1 and K2 is less than 1. Here, K1 and K2 can be values set by the user, and can be set according to a trial value or empirical value, for example. In addition, K1 and K2 are usually expressed as a percentage. Here, condition (1) indicates whether a current jump exists at this point, and condition (2) indicates whether the current jump is greater than or equal to a preset threshold so as to determine whether the current jump is a zero-sequence current jump.

The steady-state current determining module 223 is configured to determine the corresponding steady-state current at each current jump point. Here, the corresponding steady-state current at a current jump point refers to the steady-state current of the detection current waveform part between the current jump point and the previous current jump point. In one example, the steady-state current determining module 223 can determine the corresponding steady-state current at the current jump point according to a plurality of consecutive current points when said plurality of consecutive current points satisfying the following condition exist in the waveform of the detection current between the current jump point and the previous current jump point and the duration is greater than or equal to a third preset threshold:

$$(3) \quad \left| I(t) - I(t - T) \right| < k2 * \max\{I(t), I(t - T)\}$$

wherein t is the time on the waveform of the corresponding detection current at said current point, T is the sampling period of said detection current, and K2 is a second preset threshold. In addition, in one example, determining the corresponding steady-state current at said current jump point according to the corresponding current values at said plurality of consecutive current points can comprise determining the corresponding current at the first current point of said plurality of consecutive current points to be the corresponding steady-state current at said current jump point.

The characteristic waveform pattern number determining module 225 is configured to determine the number of characteristic waveform patterns contained in the waveforms of said detection currents in said preset range based on the change rate of the corresponding steady-state current at each current jump point relative to the corresponding steady-state current at the previous current jump point.

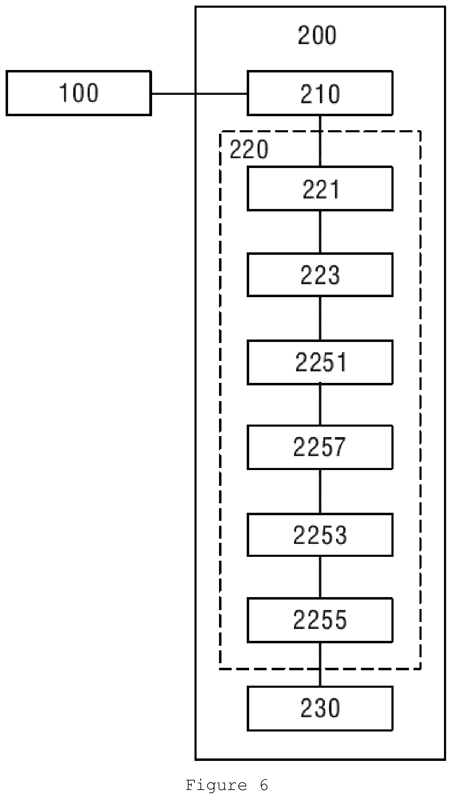

Fig. 6 shows a block diagram for a specific implementation example of the characteristic waveform pattern number determining module in Fig. 5. As shown in Fig. 6, the characteristic waveform pattern number determining module 225 can comprise a rising edge/falling edge current jump point determining submodule 2251, a time interval acquiring submodule 2253 and a characteristic waveform pattern number determining submodule 2255.

The rising edge/falling edge current jump determining submodule 2251 is configured to determine the rising edge current jump points and falling edge current jump points in the current jump points according to the change rate of the corresponding steady-state current at each current jump point relative to the corresponding steady-state current at the previous current jump point. Here, said rising edge current jump point represents a current jump point at which the waveform of said detection current changes from a steady state or falling state to a rising state, and said falling edge current jump point represents a current jump point at which the waveform of said detection current changes from a steady state or rising state to a falling state.

In one example, the rising edge/falling edge current jump point determining submodule 2251 can determine whether each current jump point is a rising edge current jump point, or a falling edge current jump point, or neither of them in the following way: First, the rising edge/falling edge current jump point determining submodule 2251 acquires the change rate $\Delta I\%$ of the corresponding steady-state current $I_{steady}(n)$ at the current jump point relative to the steady-state current $I_{steady}(n-1)$ at the previous current jump point, wherein $\Delta I\% = [(I_{steady}(n) - I_{steady}(n - 1)]/\max[I_{steady}(n), I_{steady}(n - 1)] * 100\%$ , max is a maximizing function. Next, the rising edge/falling edge current jump point determining submodule 2251 determines whether the difference $\Delta I$ is less than $- \Delta I_{threshold}\%$ or greater than $\Delta I_{threshold}\%$ , or $- \Delta I_{threshold}\% \leq \Delta I \leq \Delta I_{threshold}\%$. The rising edge/falling edge current jump point determining submodule determines the current jump point to be a falling edge current jump point when the difference $\Delta I$ is less than $- \Delta I_{threshold}\%$, to be a rising edge current jump point when the difference is greater than $\Delta I_{threshold}\%$, and to be neither a rising edge current jump point nor a falling edge current jump point when $- \Delta I_{threshold}\% \leq \Delta I \leq \Delta I_{threshold}\%$ . Here, $\Delta I_{threshold}\%$ can be set according to the power system compensation grid parameters, including inductance and reactance of the extinction coil, capacitance of the parallel capacitor, and capacitance of a line to the ground. $\Delta I_{threshold}\%$ can be an empirical value or a trial value.

The time interval acquiring submodule 2253 is configured to acquire the time intervals between each rising edge current jump point and the two adjacent falling edge current jump points of said rising edge current jump point. Then the characteristic waveform pattern number determining submodule 2255 determines the number of characteristic waveform patterns contained in the waveforms of the detection currents in said preset range based on the acquired corresponding two time intervals of each rising edge current jump point and the enabling duration and disabling duration of said capacitor.

In one example, the characteristic waveform pattern number determining submodule 2255 can acquire for each rising edge current jump point the absolute value of the difference between the capacitor enabling duration in a pulsed control signal period and the time interval between said rising edge current jump point and the previous current jump point to obtain a first difference, acquire the absolute value of the difference between the capacitor disabling duration in a pulsed control signal period and the time interval between said rising edge current jump point and the next current jump point to obtain a second difference, determine that a characteristic waveform pattern corresponding to said rising edge current jump point exists if said first difference and said second difference are both less than or equal to a preset threshold, and count the determined characteristic waveform patterns as the number of characteristic waveform patterns contained in the waveforms of detection currents in said preset range.

In addition, alternatively, the characteristic waveform pattern number determining module 225 can further comprise a selecting submodule 2257, which is configured to select rising edge current jump points whose two adjacent current jump points are both falling edge current jump points from the determined rising edge current jump points before the time interval acquiring submodule 2253 acquires the time intervals between each rising edge current jump point and the two adjacent falling edge current jump points of said rising edge current jump point. Then, the characteristic waveform pattern number determining submodule 2255 performs the characteristic waveform pattern number determination procedure for the selected rising edge current jump point. Before the characteristic waveform pattern number determining submodule 2255 performs an operation, the selecting submodule 2257 can be used to remove the rising edge current jump points at least one of whose two adjacent current jump points is a rising edge current jump point from the rising edge current jump points determined by the rising edge/falling edge current jump point determining submodule 2251, thus reducing the processing load of the characteristic waveform pattern number determining submodule 2255.

The faulty line determining device 200 further comprises a faulty line determining unit 230, which is configured to determine that a line to be detected is a faulty line if the number of characteristic waveform patterns is greater than or equal to a preset threshold. Here, alternatively, the preset threshold can be a threshold related to the preset range. For example, if the preset range is a time range from 0s to 5s, then the corresponding preset threshold is 3. In this case, if the determined number of characteristic waveform patterns is greater than or equal to 3, the detected line is determined to be a faulty line. Otherwise, the detected line is determined to be a non-faulty line. If the preset range is a time range from 0s to 20s, then the corresponding preset threshold is 17. In this case, if the determined number of characteristic waveform patterns is greater than or equal to 17, the detected line is determined to be a faulty line. Otherwise, the detected line is determined to be a non-faulty line.

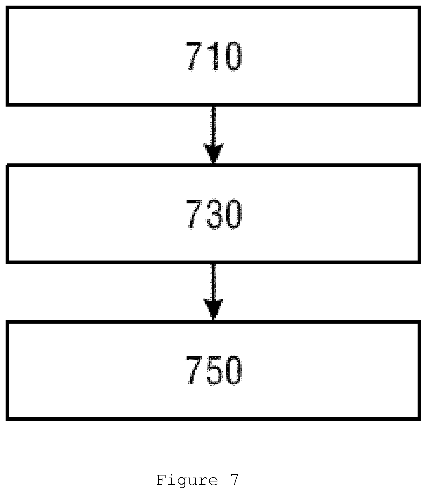

The device and the system for determining a faulty line in a power system compensation grid in the present application have been described by reference to Figs. 3 to 6. The following will describe the method for determining a faulty line in a power system compensation grid in the present application in combination with Figs. 7 to 10.

Fig. 7 shows a flowchart of the method for determining a faulty line in a power system compensation grid according to the present application. As shown in Fig. 7, first in block 710, after the current monitoring device 100 monitors a detection current on a line to be detected in the power system compensation grid, the acquiring unit 210 in the faulty line determining device 200 acquires the monitored detection current on the line to be detected from the current monitoring device 100.

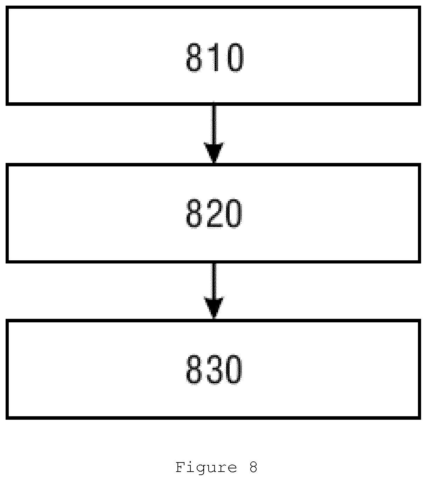

Then in block 730, the characteristic waveform pattern number determining unit 220 in the faulty line determining device 200 determines the number of characteristic waveform patterns contained in the waveform of said detection current in a preset range based on the change rate of said detection current. Fig. 8 shows a flowchart of an implementation example of the procedure of the determination of the number of characteristic waveform patterns contained in the waveforms of detection currents in a preset range based on the change rate of detection currents in Fig. 7.

As shown in Fig. 8, in block 810, determine each current jump point in the waveforms of detection currents in a preset range. For example, in one example, a current point satisfying the following two conditions in the waveform of the detection current in the preset range can be determined to be a current jump point:

$$(1) \quad \frac{\left|I(t) - I(t - T)\right|}{\left|I(t) - I(t - 2T)\right|} > K1 \text{ ,}$$

and

$$(2) \quad \left|I(t) - I(t - T)\right| > k2 * \max\left\{I(t), I(t - T)\right\} \text{ ,}$$

wherein t is the time on the waveform of the corresponding detection current at said current point, T is the sampling period of said detection current, I (t), I (t - T) and I (t - 2T) are respectively the corresponding current values at t, t-T and t-2T, K1 is a first preset threshold, K2 is a second preset threshold, K1 is greater than 1 and K2 is less than 1. Here, K1 and K2 can be values set by the user, and can be set according to a trial value or empirical value, for example. In addition, K1 and K2 are usually expressed as a percentage. Here, condition (1) indicates whether a current jump exists at this point, and condition (2) indicates whether the current jump is greater than or equal to a preset threshold so as to determine whether the current jump is a zero-sequence current jump.

Then in block 820, determine the corresponding steady-state current at each current jump point. In one example, determine the corresponding steady-state current at a current jump point according to a plurality of consecutive current points when said plurality of consecutive current points satisfying the following condition exist in the waveform of the detection current between the current jump point and the previous current jump point and the duration is greater than or equal to a third preset threshold:

$$(3) \quad \left|I(t) - I(t - T)\right| < k2 * \max\left\{I(t), I(t - T)\right\} \text{ ,}$$

wherein t is the time on the waveform of the corresponding detection current at said current point, T is the sampling period of said detection current, and K2 is a second preset threshold. In addition, in one example, determining the corresponding steady-state current at said current jump point according to the corresponding current values at said plurality of consecutive current points can comprise determining the corresponding current at the first current point of said plurality of consecutive current points to be the corresponding steady-state current at said current jump point.

Then in block 830, determine the number of characteristic waveform patterns contained in the waveforms of detection currents in said preset range based on the change rate of the corresponding steady-state current at each current jump point relative to the corresponding steady-state current at the previous current jump point

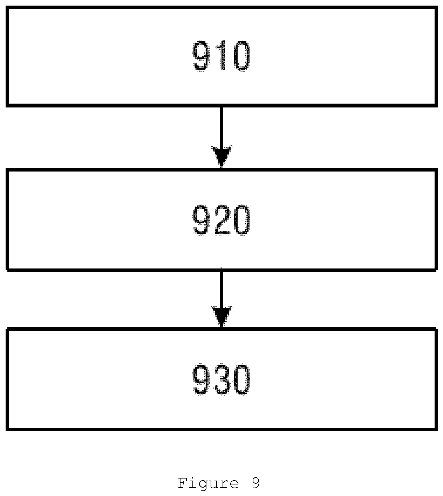

Fig. 9 shows a flowchart of an implementation example of the process of the determination of the number of characteristic waveform patterns contained in the waveforms of detection currents in a preset range based on the change rate of the corresponding steady-state current at each current jump point relative to the corresponding steady-state current at the previous current jump point in Fig. 8.

As shown in Fig.9, in block 910, determine the rising edge current jump points and the falling edge current jump points in said current jump points based on the change rate of the corresponding stead-state current at each current jump point relative to the corresponding steady-state current at the previous current jump point, wherein said rising edge current jump point represents a current jump point at which the waveform of said detection current changes from a steady state or falling state to a rising state, and said falling edge current jump point represents a current jump point at which the waveform of said detection current changes from a steady state or rising state to a falling state. For example, determine each current jump point is a rising edge current jump point, or a falling edge current jump point, or neither of them in the following way: First, acquire the change rate $\Delta I\%$ of the corresponding steady-state current $I_{steady}(n)$ at the current jump point relative to the steady-state current $I_{steady}(n-1)$ at the previous current jump point, wherein $\Delta I\% = [(I_{steady}(n) - I_{steady}(n-1)] / max[I_{steady}(n), I_{steady}(n-1)] * 100\%$ , max is a maximizing function. Then, determine whether the difference $\Delta I$ is less than $-\Delta I_{threshold}\%$ or greater than $\Delta I_{threshold}\%$ , or between the two. If the difference $\Delta I$ is less than $-\Delta I_{threshold}\%$, determine the current jump point to be a falling edge current jump point. When the difference is greater than $\Delta I_{threshold}\%$, determine the current jump point to be a rising edge current jump point. When $-\Delta I_{threshold}\% \leq \Delta I \leq \Delta I_{threshold}\%$ , determine the current jump point to be neither a rising edge current jump point nor a falling edge current jump point.

Then in block 920, for each rising edge current jump point, acquire the time intervals between said rising edge current jump point and its two adjacent falling edge current jump points.

Then in block 930, determine the number of characteristic waveform patterns contained in the waveforms of detection currents in the preset range based on the acquired two time intervals of each rising edge current jump point and the enabling duration and disabling duration of said capacitor.

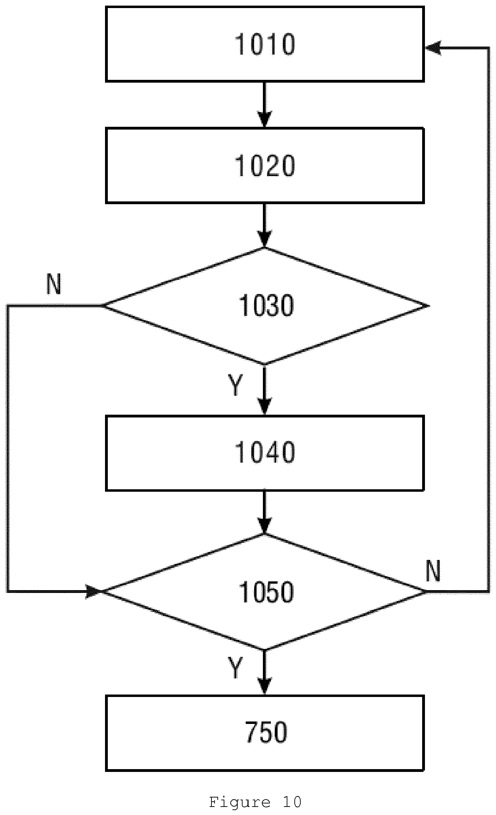

Fig. 10 shows a flowchart of an implementation example of the process of the determination of the number of characteristic waveform patterns contained in the waveforms of the detection currents in a preset range based on the acquired two time intervals of each rising edge current jump point and the enabling duration and disabling duration of said capacitor in Fig. 9.

As shown in Fig. 10, in block 1010, for each rising edge current jump point, acquire the absolute value of the difference between the enabling duration of the capacitor and the time interval between the rising edge current jump point and the previous current jump point to obtain a first difference.

In block 1020, acquire the absolute value of the difference between the disabling duration of said capacitor and the time interval between said rising edge current jump point and the next current jump point to obtain a second difference.

In block 1030, determine whether the first difference and the second difference are both less than or equal to a preset threshold.When the first difference and the second difference are both less than or equal to the preset threshold, in block 1040, determine that a characteristic waveform pattern corresponding to the rising edge current jump point exists and increase the count of characteristic waveform patterns by 1, and then go to block 1050. When the first difference or second difference is greater than the preset threshold, go to block 1050.

In block 1050, determine whether the above-mentioned characteristic waveform pattern confirmation has been completed for all rising edge current jump points. If the above-mentioned characteristic waveform pattern confirmation has been completed for all rising edge current jump points, use the number of the determined characteristic waveform patterns as the number of characteristic waveform patterns contained in the waveform of the detection current in the preset range. Otherwise, continue to go to block 1010 to perform the characteristic waveform pattern confirmation procedure for the next rising edge current jump point.

In addition, alternatively, before block 920, the method can further comprise selecting rising edge current jump points whose two adjacent current jump points are both falling edge current jump points from the determined rising edge current jump points. Then in block 920, for each selected rising edge current jump point, acquire the time intervals between said rising edge current jump point and its two adjacent falling edge current jump points.

After determining the number of characteristic waveform patterns contained in the waveform of the detection current in the preset range, in block 750, determine the line to be detected is a faulty line based on the determined number of characteristic waveform patterns. Specifically, when the determined number of characteristic waveform patterns is greater than or equal to a preset threshold, determine the line to be detected to be a faulty line. When the determined number of characteristic waveform patterns is less than the preset threshold, determine the line to be detected to be a non-faulty line.

It should be understood that the modules described by reference to Figs. 3 to 10 and the corresponding functions are used for exemplary purposes, but not for restriction purposes. The specific functions can be realized in different modules or a single module.

The method for determining a faulty line in a power system compensation grid according to the present application is executed based on the change rate of the detection current on a line to be detected. However, the change rate of a current depends only on the grid parameters, instead of the fault locations and the grounding impedance. As listed in Table 3, That is to say, the change rate of a current does not depend on the zero-sequence voltage $U_0$ on the busbar. Thus, a line with a grounding fault can reliably be selected.

| Impedance / Fault location | | 0 ohm $\Delta\ 3I_0\ \%$ | 100 ohm $\Delta\ 3I_0\ \%$ | 500 ohm $\Delta\ 3I_0\ \%$ | 1000 ohm $\Delta\ 3I_0\ \%$ | 5000 ohm $\Delta\ 3I_0\ \%$ |
|---|---|---|---|---|---|---|
| 1km | $3I_0$ | 20.38% | 20.37% | 20.12% | 19.80% | 17.44% |
| 10km | $3I_0$ | 20.20% | 20.15% | 20.00% | 19.54% | 17.46% |
| 30km | $3I_0$ | 19.97% | 19.97% | 19.81% | 19.36% | 17.30% |

Table 3

In addition, from Table 3, it can be seen that when the preset threshold for a current change rate comparison is properly selected, for example, selected as 15%, the method according to the present application can cover all the situations of different fault locations and grounding impedances. However, this cannot be realized in the prior art.

The embodiments of the method and device for determining a faulty line in a power system compensation grid according to the present application are described by reference to Figs. 3 to 10. The faulty line determining device can be realized by hardware, software or a combination of hardware and software.

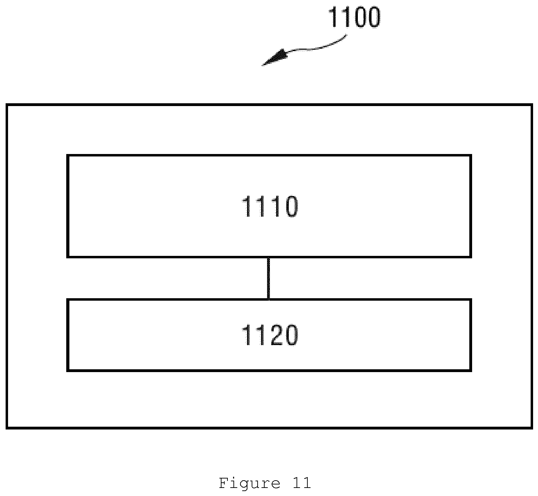

In the present application, the faulty line determining device 200 can be realized by a computing device. Fig. 11 shows a block diagram for a computing device 1100 for determining a faulty line in a power system compensation grid according to an embodiment of the present application. According to one embodiment, the computing device 1100 can comprise processors 1110. The processor 1110 executes one or more computer readable instructions (namely, the above-mentioned elements realized by software) stored or coded in a computer readable storage medium (namely, memory 1120).

In one embodiment, computer executable instructions are stored in the memory 1120. When computer executable instructions are executed, one or more processors 1110 acquires the detection current on a line to be detected in said power system compensation grid, determines the number of characteristic waveform patterns contained in the waveform of said detection current in a preset range based on the change rate of said detection current, wherein said characteristic waveform pattern is a waveform pattern reversely matching the one-period signal waveform of said pulsed clock signals, and determines that said line to be detected is a faulty line if the number of characteristic waveform patterns is greater than or equal to a preset threshold.

It should be understood that when the computer executable instructions stored in the memory 1120 are executed, one or more processors 1110 will execute various operations and functions described in the embodiments of the present application in combination with Figs. 3 to 10.

According to one embodiment, a program product, for example, non-transitory machine-readable medium, is provided. Non-transitory machine-readable medium can have instructions (namely, the above-mentioned elements realized by software). When said instructions are executed by a machine, the machine will execute various operations and functions described in the embodiments in the present application in combination with Figs. 3 to 10. Specifically, a system or device equipped with a readable storage medium can be provided. Software program codes which can realize the function in any of above-mentioned embodiments are stored in said readable storage medium and the computer or processor of the system or device can read out and execute the instructions stored in the readable storage medium.

In this case, program codes read from the readable storage medium themselves can realize the function in any of the above-mentioned embodiments. Therefore, machine-readable codes and the readable storage medium where machine-readable codes are stored constitute a part of the present invention.

Embodiments of readable storage media include floppy disks, hard disks, magneto-optical disks, compact disks (for example, compact disk read-only memory (CD-ROM)), compact disk - recordable (CD-R), compact disk - rewritable (CD-RW), digital video disk - read only memory (DVD-ROM), digital versatile disk - random access memory (DVD-RAM), digital versatile disk - rewritable (DVD-RW), magnetic tape, non-volatile memory card, and read-only memory (ROM). Alternatively, program codes can be downloaded from the server computer or cloud over a communication network.

Those skilled in the art should understand that variants and modifications can be made without departing from the essence of the present invention. Therefore, the scope of protection of the present invention should be defined by the attached claims.

It should be noted that not all steps or units in the above-mentioned flowcharts and system structure diagrams are required, and some steps or units can be ignored, depending on the actual requirements. The execution sequence of the steps is not fixed and can be adjusted as required. The device structures described in the above-mentioned embodiments can be physical structures or logical structures. That is to say, some units may be realized by a physical entity, or some units may be realized by a plurality of physical entities or may jointly be realized by some components in a plurality of self-contained devices.

In the above-mentioned embodiments, hardware units or modules can mechanically or electrically be realized. For example, a hardware unit, module or processor can comprise a permanent dedicated circuit or logic (for example, special processor, FPGA, or ASIC) to complete the corresponding operations. A hardware unit or processor can further comprise a programmable logic or circuit (for example, a general processor or other programmable processor) and can complete the corresponding operations through temporary software setting. The specific realization ways (mechanical way, or dedicated permanent circuit, or circuit which is temporarily set) can be determined on the basis of consideration of cost and time.

The embodiments described above in combination with the drawings are only exemplary embodiments, but do not represent all embodiments that can be realized or fall within the scope of protection of the claims. The term "exemplary" used in the whole description means "used as an example, instance or illustration", but does not mean "preferable" to or "advantageous" over other embodiments. For the purpose of providing an understanding of the described techniques, the embodiments cover specific details. However, these techniques can be carried out without these specific details. In some embodiments, well-known structures and devices are shown in the form of a block diagram to avoid the difficulty in understanding the concepts in the described embodiments.

The above-mentioned description of the present disclosure is provided so that those skilled in the art can realize or use the present disclosure. Various modifications to the present disclosure are apparent to those skilled in the art, and in addition, the general principle defined in this document can be applied to other variants, without departing from the scope of protection of the present disclosure. Therefore, the present disclosure is not limited to the examples and designs in this document, but is consistent with the widest scope of the principle and novelty characteristics disclosed in this document.

**Claims**

1. A method for determining a faulty line in a power system compensation grid, wherein the power system compensation grid is a power system grid whose neutral point is not directly grounded, wherein said power system compensation grid comprising a plurality of lines connected to a busbar, a pulse clock equipment (4) configured to generate pulsed clock signals and a zero-sequence current in each line of said plurality of lines, an extinction coil (52), a capacitor (51) connected in parallel with said extinction coil and a transformer connected with said busbar, said extinction coil (52) is connected with the neutral point of said transformer (2), and said method comprising:

   - using pulsed clock signals generated by the pulse clock equipment (4) to periodically enable/disable said capacitor to periodically generate detection currents on each line of said plurality of lines if a grounding fault happens in said power system compensation grid, wherein the enabling duration of said capacitor is preferably not equal to the disabling duration of said capacitor;
   - acquiring (710) the detection currents on a line to be detected in said power system compensation grid,
   - determining (730) a number of characteristic waveform patterns contained in waveforms of said detection currents in a preset range based on a change rate of said detection currents, wherein a characteristic waveform pattern is a waveform pattern reversely matching a one-period signal waveform of said pulsed clock signals, and
   - determining (750) that said line to be detected is a faulty line if the number of characteristic waveform patterns is greater than or equal to a preset threshold,

**characterized in that**

determining (730) the number of characteristic waveform patterns contained in the waveforms of said detection currents in the preset range based on the change rate of said detection currents comprises:

- determining (810) each current jump point in the waveforms of the detection currents in said preset range, wherein at a current jump point the current changes from a rising state or a steady state to a falling state, or from a falling state or a steady state to a rising state,
- determining (820) the corresponding steady-state current at each current jump point, and
- determining (830) the number of characteristic waveform patterns contained in the waveforms of said detection currents in said preset range based on the change rate of the corresponding steady-state current at each current jump point relative to the corresponding steady-state current at the previous current jump point.

2. The method as claimed in claim 1, wherein (830) determining the number of characteristic waveform patterns contained in the waveforms of said detection currents in said preset range based on the change rate of the corresponding steady-state current at each current jump point relative to the corresponding steady-state current at the previous current jump point comprises:

- determining (910) the rising edge current jump points and the falling edge current jump points in said current jump points based on the change rate of the corresponding stead-state current at each current jump point relative to the corresponding steady-state current at the previous current jump point, wherein said rising edge current jump point represents a current jump point at which the waveform of said detection current changes from a steady state or falling state to a rising state, and said falling edge current jump point represents a current jump point at which the waveform of said detection current changes from a steady state or rising state to a falling state,
- selecting rising edge current jump points whose two adjacent current jump points are both falling edge current jump points from the determined rising edge current jump points,
- acquiring (920) the time intervals between said current jump point and the two adjacent falling edge current jump points for each selected rising edge current jump point, and
- determining (930) the number of characteristic waveform patterns contained in the waveforms of the detection currents in said preset range based on the acquired corresponding two time intervals of each rising edge current jump point and the enabling duration and disabling duration of said capacitor.

3. The method as claimed in claim 1, wherein determining each current jump point in the waveforms of the detection currents in said preset range comprises:

- determining a current point satisfying the following two conditions in the waveforms of said detection currents to be a current jump point:

$$\frac{|I(t) - I(t - T)|}{|I(t) - I(t - 2T)|} > K1 \, ,$$

$$|I(t) - I(t - T)| > k2 * \max\{I(t), I(t - T)\} \, ,$$

- wherein, t is the time on the waveform of the corresponding detection current at said current point, T is the sampling period of said detection current, I (t), I (t - T) and I (t - 2T) are respectively the corresponding current values at t, t-T and t-2T, K1 is a first preset threshold, K2 is a second preset threshold, K1 is greater than 1 and K2 is less than 1, and determining the corresponding steady-state current at each current jump point comprises:

- determining the corresponding steady-state current at said current jump point according to the corresponding current values at said plurality of consecutive current points when a plurality of consecutive current points satisfying the following condition exist in the waveforms of the detection currents between said current jump point and the previous current jump point and the duration is greater than or equal to a third preset threshold:

$$\left|\mathrm{I}\left(\mathrm{t}\right)-\mathrm{I}\left(\mathrm{t}-\mathrm{T}\right)\right| < k2 * \max\left\{\mathrm{I}\left(\mathrm{t}\right), \mathrm{I}\left(\mathrm{t}-\mathrm{T}\right)\right\},$$

wherein determining the corresponding steady-state current at said current jump point according to the corresponding current values at said plurality of consecutive current points preferably comprises:

- determining the corresponding current at the first current point of said plurality of consecutive current points to be the corresponding steady-state current at said current jump point.

4. The method as claimed in claim 2, wherein determining (930) the number of characteristic waveform patterns contained in the waveforms of the detection currents in said preset range based on the acquired corresponding two time intervals of each rising edge current jump point and the enabling duration and disabling duration of said capacitor comprises:

  - for each rising edge current jump point,
  - acquiring (1010) the absolute value of the difference between the enabling duration of said capacitor and the time interval between said rising edge current jump point and the previous current jump point to obtain a first difference,
  - acquiring (1020) the absolute value of the difference between the disabling duration of said capacitor and the time interval between said rising edge current jump point and the next current jump point to obtain a second difference, and
  - if said first difference and said second difference are both less than or equal to a preset threshold, determining that a characteristic waveform pattern corresponding to said rising edge current jump point exists, and
  - counting the determined characteristic waveform patterns as the number of characteristic waveform patterns contained in the waveforms of detection currents in said preset range.

5. A device for determining a faulty line in a power system compensation grid, said power system compensation grid comprising a plurality of lines (7-1, 7-2, 7-3) connected to a busbar (6), a pulse clock equipment (4), an extinction coil (52), a capacitor (51) connected in parallel with said extinction coil and a transformer connected with said busbar, said extinction coil (52) is connected with the neutral point of said transformer (2), and the pulse clock equipment (4) being configured to generate zero sequence currents on each of the plurality of lines and to generate pulsed clock signals to periodically enable/disable said capacitor to periodically generate detection currents on each line of said plurality of lines if a grounding fault happens in said power system compensation grid, wherein the enabling duration of said capacitor is preferably not equal to the disabling duration of said capacitor, and said device comprising:

  - an acquiring unit (210), configured to acquire detection currents on a line to be detected in said power system compensation grid,
  - a characteristic waveform pattern number determining unit (220), configured to determine the number of characteristic waveform patterns contained in the waveforms of said detection currents in a preset range based on the change rate of said detection currents, wherein said characteristic waveform pattern is a waveform pattern reversely matching the one-period signal waveform of said pulsed clock signals, and
  - a faulty line determining unit (230), configured to determine that said line to be detected is a faulty line if the number of characteristic waveform patterns is greater than or equal to a preset threshold,

**characterized in that**
said characteristic waveform pattern number determining unit (220) comprises:

  - a current jump point determining module (221), configured to determine each current jump point in the waveforms of detection currents in said preset range, wherein at a current jump point the current changes from a rising state or a steady state to a falling state, or from a falling state or a steady state to a rising state,
  - a steady-state current determining module (223), configured to determine the corresponding steady-state current at each current jump point, and
  - a characteristic waveform pattern number determining module (225), configured to determine the number of characteristic waveform patterns contained in the waveforms of said detection currents in said preset range based on the change rate of the corresponding steady-state current at each current jump point relative to the corresponding steady-state current at the previous current jump point.

6. The device as claimed in claim 5, wherein said characteristic waveform pattern number determining module (225) comprises:

- a rising edge/falling edge current jump point determining submodule (2251), configured to determine the rising edge current jump points and the falling edge current jump points in said current jump points based on the change rate of the corresponding stead-state current at each current jump point relative to the corresponding steady-state current at the previous current jump point, wherein said rising edge current jump point represents a current jump point at which the waveform of said detection current changes from a steady state or falling state to a rising state, and said falling edge current jump point represents a current jump point at which the waveform of said detection current changes from a steady state or rising state to a falling state,
- a selecting submodule (2257), configured to select rising edge current jump points whose two adjacent current jump points are both falling edge current jump points from the determined rising edge current jump points,
- a time interval acquiring submodule (2253), configured to acquire the time intervals between said current jump point and the two adjacent falling edge current jump points for each selected rising edge current jump point, and
- a characteristic waveform pattern number determining submodule (2255), configured to determine the number of characteristic waveform patterns contained in the waveforms of the detection currents in said preset range based on the acquired corresponding two time intervals of each rising edge current jump point and the enabling duration and disabling duration of said capacitor.

7. The device as claimed in claim 5, wherein said current jump point determining module (221) is configured to

- determine a current point satisfying the following two conditions in the waveforms of said detection currents to be a current jump point:

$$\frac{|I(t) - I(t - T)|}{|I(t) - I(t - 2T)|} > K1 ;$$

$$|I(t) - I(t - T)| > k2 * \max\{I(t), I(t - T)\} ,$$

- wherein, t is the time on the waveform of the corresponding detection current at said current point, T is the sampling period of said detection current, I (t), I (t - T) and I (t - 2T) are respectively the corresponding current values at t, t-T and t-2T, K1 is a first preset threshold, K2 is a second preset threshold, K1 is greater than 1 and K2 is less than 1,
- said steady-state current determining module 223 is configured to
- determine the corresponding steady-state current at said current jump point according to the corresponding current values at said plurality of consecutive current points when a plurality of consecutive current points satisfying the following condition exist in the waveforms of the detection currents between said current jump point and the previous current jump point and the duration is greater than or equal to a third preset threshold:

$$|I(t) - I(t - T)| < k2 * \max\{I(t), I(t - T)\} .$$

8. The device as claimed in claim 7, wherein said steady-state current determining module (223) is configured to

- determine the corresponding current at the first current point of said plurality of consecutive current points to be the corresponding steady-state current at said current jump point.

9. The device as claimed in claim 6, wherein said characteristic waveform pattern number determining submodule (2255) is configured to

- for each rising edge current jump point,
- acquire the absolute value of the difference between the enabling duration of said capacitor and the time interval between said rising edge current jump point and the previous current jump point to obtain a first difference,
- acquire the absolute value of the difference between the disabling duration of said capacitor and the time interval between said rising edge current jump point and the next current jump point to obtain a second difference, and

- if said first difference and said second difference are both less than or equal to a preset threshold, determine that a characteristic waveform pattern corresponding to said rising edge current jump point exists, and
- count the determined characteristic waveform patterns as the number of characteristic waveform patterns contained in the waveforms of detection currents in said preset range.

**10.** A computing device, comprising:

- processors, and
- a memory coupled with said processors, configured to store instructions, wherein when said instructions are executed by said one or more processors, said processors will execute the method as claimed in any of claims 1 to 4.

**11.** A machine readable storage medium, storing executable instructions, wherein when said instructions are executed, said machine will execute the method as claimed in any of claims 1 to 4.

**Patentansprüche**

**1.** Verfahren zum Bestimmen einer fehlerhaften Leitung in einem Kompensationsnetz eines Leistungssystems, wobei das Kompensationsnetz des Leistungssystems ein Energieversorgungsnetz ist, dessen Sternpunkt nicht direkt geerdet ist,

wobei das Leistungssystem-Kompensationsnetz eine Vielzahl von Leitungen, die mit einer Sammelschiene verbunden sind, ein Impulstaktgerät (4), das so konfiguriert ist, dass es gepulste Taktsignale und einen Nullstrom in jeder Leitung der Vielzahl von Leitungen erzeugt, eine Löschspule (52), einen Kondensator (51), der parallel zu der Löschspule geschaltet ist, und einen Transformator, der mit der Sammelschiene verbunden ist, umfasst, wobei die Löschspule (52) mit dem Nullpunkt des Transformators (2) verbunden ist, und wobei das Verfahren Folgendes umfasst:

- Verwenden von gepulsten Taktsignalen, die von dem Impulstaktgerät (4) erzeugt werden, um den Kondensator periodisch zu aktivieren/deaktivieren, um periodisch Erfassungsströme auf jeder Leitung der Vielzahl von Leitungen zu erzeugen, wenn ein Erdungsfehler in dem Leistungssystem-Kompensationsnetz auftritt,

wobei die Aktivierungsdauer des Kondensators vorzugsweise nicht gleich der Deaktivierungsdauer des Kondensators ist;

- Erfassen (710) der Erfassungsströme auf einer zu erfassenden Leitung im Leistungssystem-Kompensationsnetz,
- Bestimmen (730) einer Anzahl von charakteristischen Wellenformmustern, die in Wellenformen der Erfassungsströme in einem voreingestellten Bereich enthalten sind, basierend auf einer Änderungsrate der Erfassungsströme,

wobei ein charakteristisches Wellenformmuster ein Wellenformmuster ist, das in umgekehrter Richtung zu einer einperiodigen Signalwellenform der gepulsten Taktsignale passt, und

- Bestimmen (750), dass es sich bei der zu erfassenden Leitung um eine fehlerhafte Leitung handelt, wenn die Anzahl der charakteristischen Wellenformmuster größer oder gleich einem voreingestellten Schwellenwert ist,

durch Folgendes gekennzeichnet:

- wobei das Bestimmen (730) der Anzahl von charakteristischen Wellenformmustern, die in den Wellenformen der Erfassungsströme in dem voreingestellten Bereich enthalten sind, basierend auf der Änderungsrate der Erfassungsströme, Folgendes umfasst:

- Bestimmen (810) jedes Stromsprungpunktes in den Wellenformen der Erfassungsströme in dem voreingestellten Bereich,

wobei der Strom an einem Stromsprungpunkt von einem ansteigenden Zustand oder einem gleichmäßigen Zustand in einen abfallenden Zustand oder von einem abfallenden Zustand oder einem gleichmäßigen Zustand in einen ansteigenden Zustand übergeht,

- Bestimmen (820) des entsprechenden Ruhestroms an jedem Stromsprungpunkt, und
- Bestimmen (830) der Anzahl von charakteristischen Wellenformmustern, die in den Wellenformen der Erfassungsströme in dem voreingestellten Bereich enthalten sind, basierend auf der Änderungsrate des entsprechenden Ruhestroms an jedem Stromsprungpunkt relativ zu dem entsprechenden Ruhestrom an dem vorherigen Stromsprungpunkt.

2. Verfahren nach Anspruch 1, wobei (830) das Bestimmen der Anzahl charakteristischer Wellenformmuster, die in den Wellenformen der Erfassungsströme in dem vorgegebenen Bereich enthalten sind, auf der Grundlage der Änderungsrate des entsprechenden Ruhestroms an jedem Stromsprungpunkt relativ zu dem entsprechenden Ruhestrom am vorherigen Stromsprungpunkt Folgendes umfasst:

- Bestimmen (910) der Stromsprungpunkte der ansteigenden Flanke und der Stromsprungpunkte der abfallenden Flanke in den Stromsprungpunkten auf der Grundlage der Änderungsrate des entsprechenden Ruhestroms an jedem Stromsprungpunkt relativ zu dem entsprechenden Ruhestrom am vorherigen Stromsprungpunkt, wobei der Stromsprungpunkt der ansteigenden Flanke einen Stromsprungpunkt darstellt, an dem sich die Wellenform des Erfassungsstroms von einem stationären oder fallenden Zustand zu einem ansteigenden Zustand ändert, und der Stromsprungpunkt der abfallenden Flanke einen Stromsprungpunkt darstellt, an dem sich die Wellenform des Erfassungsstroms von einem stationären oder steigenden Zustand zu einem fallenden Zustand ändert,
- Auswählen von Stromsprungpunkten mit steigender Flanke, deren zwei benachbarte Stromsprungpunkte beide Stromsprungpunkte mit fallender Flanke sind, aus den ermittelten Stromsprungpunkten mit steigender Flanke,
- Erfassen (920) der Zeitintervalle zwischen dem Stromsprungpunkt und den beiden benachbarten Stromsprungpunkten der fallenden Flanke für jeden ausgewählten Stromsprungpunkt der steigenden Flanke, und
- Bestimmen (930) der Anzahl von charakteristischen Wellenformmustern, die in den Wellenformen der Erfassungsströme in dem voreingestellten Bereich enthalten sind, auf der Grundlage der erfassten entsprechenden zwei Zeitintervalle jedes Stromsprungpunkts mit steigender Flanke und der Aktivierungsdauer und Deaktivierungsdauer des Kondensators.

3. Verfahren nach Anspruch 1, wobei die Bestimmung jedes Stromsprungpunktes in den Wellenformen der Erfassungsströme in dem voreingestellten Bereich Folgendes umfasst:

- Bestimmen eines Strompunktes, der die beiden folgenden Bedingungen in den Wellenformen der Erfassungsströme erfüllt, als Stromsprungpunkt:

$$\frac{|I(t)-I(t-T)|}{|I(t)-I(t-2T)|} > K1,$$

$$|I(t) - I(t - T) > k2 * max\{I(t), I(t - T)\}|$$

- wobei t die Zeit auf der Wellenform des entsprechenden Erfassungsstroms an dem Strompunkt ist, T die Abtastperiode des Erfassungsstroms ist, I(t), I(t-T) und I(t-2T) jeweils die entsprechenden Stromwerte bei t, t-T und t-2T sind, K1 ein erster voreingestellter Schwellenwert ist, K2 ein zweiter voreingestellter Schwellenwert ist, K1 größer als 1 ist und K2 kleiner als 1 ist, und das Bestimmen des entsprechenden Ruhestroms an jedem Stromsprungpunkt Folgendes umfasst:

- Bestimmen des entsprechenden Ruhestroms an dem Stromsprungpunkt gemäß den entsprechenden Stromwerten an der Vielzahl von aufeinanderfolgenden Strompunkten, wenn eine Vielzahl von aufeinanderfolgenden Strompunkten, die die folgende Bedingung erfüllen, in den Wellenformen der Erfassungsströme zwischen dem Stromsprungpunkt und dem vorherigen Stromsprungpunkt vorhanden sind und die Dauer größer oder gleich einem dritten voreingestellten Schwellenwert ist;

$$|I(t) - I(t - T) < k2 * max\{I(t), I(t - T)\}|$$

wobei das Bestimmen des entsprechenden Ruhestroms an dem Stromsprungpunkt gemäß den entsprechenden Stromwerten an der Vielzahl von aufeinanderfolgenden Strompunkten vorzugsweise Folgendes umfasst:

- Bestimmen des entsprechenden Stroms am ersten Strompunkt der mehreren aufeinanderfolgenden Strompunkte als den entsprechenden Ruhestrom an dem Stromsprungpunkt.

4. Verfahren nach Anspruch 2, wobei das Bestimmen (930) der Anzahl von charakteristischen Wellenformmustern, die in den Wellenformen der Erfassungsströme in dem voreingestellten Bereich enthalten sind, auf der Grundlage der erfassten entsprechenden zwei Zeitintervalle jedes Stromsprungpunkts mit steigender Flanke und der Aktivierungsdauer und Deaktivierungsdauer des Kondensators Folgendes umfasst:

- für jeden Stromsprungpunkt mit steigender Flanke,
- Erfassen (1010) des Absolutwerts der Differenz zwischen der Aktivierungsdauer des Kondensators und dem Zeitintervall zwischen dem Stromsprungpunkt der ansteigenden Flanke und dem vorherigen Stromsprungpunkt, um eine erste Differenz zu erhalten,
- Erfassen (1020) des Absolutwerts der Differenz zwischen der Deaktivierungsdauer des Kondensators und dem Zeitintervall zwischen dem Stromsprungpunkt der steigenden Flanke und dem nächsten Stromsprungpunkt, um eine zweite Differenz zu erhalten, und
- wenn die erste Differenz und die zweite Differenz beide kleiner oder gleich einem voreingestellten Schwellenwert sind, Bestimmen, dass ein charakteristisches Wellenformmuster existiert, das dem Stromsprungpunkt mit steigender Flanke entspricht, und
- zählen der ermittelten charakteristischen Wellenformmuster als die Anzahl der charakteristischen Wellenformmuster, die in den Wellenformen der Erfassungsströme in dem voreingestellten Bereich enthalten sind.

5. Vorrichtung zum Bestimmen einer fehlerhaften Leitung in einem Leistungssystem-Kompensationsnetz, wobei das Leistungssystem-Kompensationsnetz eine Vielzahl von Leitungen (7-1, 7-2, 7-3), die mit einer Sammelschiene (6) verbunden sind, ein Impulstaktgerät (4), eine Löschspule (52), einen Kondensator (51), der parallel zu der Löschspule geschaltet ist, und einen Transformator, der mit der Sammelschiene verbunden ist, umfasst, wobei die Löschspule (52) mit dem Sternpunkt des Transformators (2) verbunden ist, und das Impulstaktgerät (4) so konfiguriert ist, dass es Nullströme auf jeder der Vielzahl von Leitungen erzeugt und gepulste Taktsignale erzeugt, um den Kondensator periodisch zu aktivieren/deaktivieren, um periodisch Erfassungsströme auf jeder Leitung der Vielzahl von Leitungen zu erzeugen, wenn ein Erdungsfehler in dem Leistungssystem-Kompensationsnetz auftritt,

wobei die Aktivierungsdauer des Kondensators vorzugsweise nicht gleich der Deaktivierungsdauer des Kondensators ist, und die Vorrichtung Folgendes umfasst:

- eine Erfassungseinheit (210), die so konfiguriert ist, dass sie Erfassungsströme auf einer zu erfassenden Leitung in dem Leistungssystem-Kompensationsnetz erfasst,
- eine Einheit (220) zum Bestimmen der Anzahl charakteristischer Wellenformmuster, die so konfiguriert ist, dass sie die Anzahl charakteristischer Wellenformmuster bestimmt, die in den Wellenformen der Erfassungsströme in einem voreingestellten Bereich auf der Grundlage der Änderungsrate der Erfassungsströme enthalten sind,

wobei das charakteristische Wellenformmuster ein Wellenformmuster ist, das der einperiodigen Signalwellenform der gepulsten Taktsignale entgegengesetzt entspricht, und

- eine Einheit (230) zum Bestimmen einer fehlerhaften Leitung, die so konfiguriert ist, dass sie bestimmt, dass die zu erfassende Leitung eine fehlerhafte Leitung ist, wenn die Anzahl der charakteristischen Wellenformmuster größer oder gleich einem voreingestellten Schwellenwert ist,

durch Folgendes gekennzeichnet:
wobei die Einheit (220) zum Bestimmen der Anzahl charakteristischer Wellenformmuster Folgendes umfasst:

- ein Stromsprungpunkt-Bestimmungsmodul (221), das so konfiguriert ist, dass es jeden Stromsprungpunkt in den Wellenformen der Erfassungsströme in dem voreingestellten Bereich bestimmt,

wobei der Strom an einem Stromsprungpunkt von einem ansteigenden Zustand oder einem gleichmäßigen Zustand in einen abfallenden Zustand oder von einem abfallenden Zustand oder einem gleichmäßigen Zustand in einen ansteigenden Zustand übergeht,

- ein Ruhestrom-Bestimmungsmodul (223), das so konfiguriert ist, dass es den entsprechenden Ruhestrom an jedem Stromsprungpunkt bestimmt, und
- ein Modul (225) zum Bestimmen der Anzahl der charakteristischen Wellenformmuster, das so konfiguriert ist, dass es die Anzahl der charakteristischen Wellenformmuster bestimmt, die in den Wellenformen der Erfassungsströme in dem voreingestellten Bereich enthalten sind, und zwar auf der Grundlage der Änderungsrate des entsprechenden Ruhestroms an jedem Stromsprungpunkt relativ zu dem entsprechenden Ruhestrom an dem vorherigen Stromsprungpunkt.

6. Vorrichtung nach Anspruch 5, wobei das Modul (225) zum Bestimmen der Anzahl charakteristischer Wellenformmuster Folgendes umfasst:

- ein Submodul (2251) zum Bestimmen von Stromsprungpunkten mit steigender Flanke/fallender Flanke, das so konfiguriert ist, dass es die Stromsprungpunkte mit steigender Flanke und die Stromsprungpunkte mit fallender Flanke in den Stromsprungpunkten auf der Grundlage der Änderungsrate des entsprechenden Ruhestroms an jedem Stromsprungpunkt relativ zu dem entsprechenden Ruhestrom am vorherigen Stromsprungpunkt bestimmt,
wobei der Stromsprungpunkt der ansteigenden Flanke einen Stromsprungpunkt darstellt, an dem sich die Wellenform des Erfassungsstroms von einem stationären oder fallenden Zustand zu einem ansteigenden Zustand ändert, und der Stromsprungpunkt der abfallenden Flanke einen Stromsprungpunkt darstellt, an dem sich die Wellenform des Erfassungsstroms von einem stationären oder steigenden Zustand zu einem fallenden Zustand ändert,
- ein Auswahl-Submodul (2257), das konfiguriert ist, um Stromsprungpunkte mit steigender Flanke, deren zwei benachbarte Stromsprungpunkte beide Stromsprungpunkte mit fallender Flanke sind, aus den ermittelten Stromsprungpunkten mit steigender Flanke auszuwählen,
- ein Zeitintervall-Erfassungs-Submodul (2253), das so konfiguriert ist, dass es die Zeitintervalle zwischen dem aktuellen Sprungpunkt und den zwei benachbarten Stromsprungpunkten mit fallender Flanke für jeden ausgewählten Stromsprungpunkt mit steigender Flanke erfasst, und
- ein Submodul (2255) zum Bestimmen der Anzahl der charakteristischen Wellenformmuster, das so konfiguriert ist, dass es die Anzahl der charakteristischen Wellenformmuster, die in den Wellenformen der Erfassungsströme in dem voreingestellten Bereich enthalten sind, auf der Grundlage der erfassten entsprechenden zwei Zeitintervalle jedes Stromsprungpunkts mit steigender Flanke und der Aktivierungsdauer und der Deaktivierungsdauer des Kondensators bestimmt.

7. Vorrichtung nach Anspruch 5, wobei das Stromsprungpunkt-Bestimmungsmodul (221) für Folgendes konfiguriert ist:

- Bestimmen eines Strompunkts, der die beiden folgenden Bedingungen in den Wellenformen der Erfassungsströme erfüllt, als Stromsprungpunkt:

$$\frac{|I(t)-I(t-T)|}{|I(t)-I(t-2T)|} > K1,$$

$$|I(t) - I(t - T) > k2 * max\{I(t), I(t - T)\}|$$

wobei t die Zeit auf der Wellenform des entsprechenden Erfassungsstroms an dem Strompunkt ist, T die Abtastperiode des Erfassungsstroms ist, I(t), I(t-T) und I(t-2T) jeweils die entsprechenden Stromwerte bei t, t-T und t-2T sind, K1 ein erster voreingestellter Schwellenwert ist, K2 ein zweiter voreingestellter Schwellenwert ist, K1 größer als 1 ist und K2 kleiner als 1 ist,
- wobei das Ruhestrom-Bestimmungsmodul 223 für Folgendes konfiguriert ist:

- Bestimmen des entsprechenden Ruhestroms an dem Stromsprungpunkt gemäß den entsprechenden Stromwerten an der Vielzahl von aufeinanderfolgenden Strompunkten, wenn eine Vielzahl von aufeinanderfolgenden Strompunkten, die die folgende Bedingung erfüllen, in den Wellenformen der Erfassungsströme zwischen dem Stromsprungpunkt und dem vorherigen Stromsprungpunkt vorhanden sind und die Dauer größer oder gleich einem dritten voreingestellten Schwellenwert ist:

$$|I(t) - I(t - T) < k2 * max\{I(t), I(t - T)\}|$$

**8.** Vorrichtung nach Anspruch 7, wobei das Ruhestrom-Bestimmungsmodul (223) für Folgendes konfiguriert ist:

- Bestimmen des entsprechenden Stroms am ersten Strompunkt der Vielzahl von aufeinanderfolgenden Strompunkten als den entsprechenden Ruhestrom am Stromsprungpunkt.

**9.** Vorrichtung nach Anspruch 6, wobei das Submodul (2255) zum Bestimmen der Anzahl charakteristischer Wellenformmuster für Folgendes konfiguriert ist:

- für jeden Stromsprungpunkt mit steigender Flanke,
- Erfassen des Absolutwertes der Differenz zwischen der Aktivierungsdauer des Kondensators und dem Zeitintervall zwischen dem Stromsprungpunkt der ansteigenden Flanke und dem vorherigen Stromsprungpunkt, um eine erste Differenz zu erhalten,
- Erfassen des Absolutwertes der Differenz zwischen der Deaktivierungsdauer des Kondensators und dem Zeitintervall zwischen dem Stromsprungpunkt der ansteigenden Flanke und dem nächsten Stromsprungpunkt, um eine zweite Differenz zu erhalten, und
- falls die erste Differenz und die zweite Differenz beide kleiner oder gleich einem voreingestellten Schwellenwert sind, Bestimmen, dass ein charakteristisches Wellenformmuster entsprechend dem Stromsprungpunkt der steigenden Flanke existiert, und
- Zählen der ermittelten charakteristischen Wellenformmuster als die Anzahl der charakteristischen Wellenformmuster, die in den Wellenformen der Erfassungsströme in dem voreingestellten Bereich enthalten sind.

**10.** Rechenvorrichtung, die Folgendes umfasst:

- Prozessoren, und
- einen mit den Prozessoren gekoppelten Speicher, der so konfiguriert ist, dass er Anweisungen speichert, wobei die Prozessoren, wenn die Anweisungen von dem einen oder den mehreren Prozessoren ausgeführt werden, das in einem der Ansprüche 1 bis 4 beanspruchte Verfahren ausführen.

**11.** Maschinenlesbares Speichermedium, das ausführbare Anweisungen speichert, wobei die Maschine, wenn die Anweisungen ausgeführt werden, das in einem der Ansprüche 1 bis 4 beanspruchte Verfahren ausführen wird.

**Revendications**

**1.** Procédé de détermination d'une ligne défectueuse dans un réseau de compensation de système de puissance, le réseau de compensation de système de puissance étant un réseau de système de puissance dont le point neutre n'est pas directement mis à la terre, ledit réseau de compensation de système de puissance comprenant une pluralité de lignes connectées à une barre omnibus, un équipement d'horloge à impulsions (4) configuré pour générer des signaux d'horloge à impulsions et un courant homopolaire dans chaque ligne de ladite pluralité de lignes, une bobine d'extinction (52), un condensateur (51) connecté en parallèle avec ladite bobine d'extinction et un transformateur connecté avec ladite barre omnibus, ladite bobine d'extinction (52) étant connectée avec le point neutre dudit transformateur (2), et ledit procédé comprenant :

l'utilisation de signaux d'horloge à impulsions générés par l'équipement d'horloge à impulsions (4) pour activer/désactiver périodiquement ledit condensateur afin de générer périodiquement des courants de détection sur chaque ligne de ladite pluralité de lignes si un défaut de mise à la terre survient dans ledit réseau de compensation de système de puissance, la durée d'activation dudit condensateur n'étant de préférence pas égale à la durée de désactivation dudit condensateur ;
l'acquisition (710) des courants de détection sur une ligne à détecter dans ledit réseau de compensation de système de puissance,
la détermination (730) d'un nombre de motifs de forme d'onde caractéristique contenus dans des formes d'onde desdits courants de détection dans un intervalle prédéfini sur la base d'un taux de changement desdits courants de détection, un motif de forme d'onde caractéristique étant un motif de forme d'onde correspondant inversement à une forme d'onde de signal à une période desdits signaux d'horloge à impulsions, et

la détermination (750) que ladite ligne à détecter est une ligne défectueuse si le nombre de motifs de forme d'onde caractéristique est supérieur ou égal à un seuil prédéfini, **caractérisé en ce que**

la détermination (730) du nombre de motifs de forme d'onde caractéristique contenus dans les formes d'onde desdits courants de détection dans l'intervalle prédéfini sur la base du taux de changement desdits courants de détection comprend :

la détermination (810) de chaque point de saut de courant dans les formes d'onde des courants de détection dans ledit intervalle prédéfini, à un point de saut de courant le courant changeant d'un état montant ou d'un état stable à un état descendant, ou d'un état descendant ou d'un état stable à un état montant,

la détermination (820) du courant d'état stable correspondant à chaque point de saut de courant, et

la détermination (830) du nombre de motifs de forme d'onde caractéristique contenus dans les formes d'onde desdits courants de détection dans ledit intervalle prédéfini sur la base du taux de changement du courant d'état stable correspondant à chaque point de saut de courant par rapport au courant d'état stable correspondant au point de saut de courant précédent.

2. Procédé selon la revendication 1, la détermination (830) du nombre de motifs de forme d'onde caractéristique contenus dans les formes d'onde desdits courants de détection dans ledit intervalle prédéfini sur la base du taux de changement du courant d'état stable correspondant à chaque point de saut de courant par rapport au courant d'état stable correspondant au point de saut de courant précédent comprenant :

la détermination (910) des points de saut de courant en front montant et des points de saut de courant en front descendant dans lesdits points de saut de courant sur la base du taux de changement du courant d'état stable correspondant à chaque point de saut de courant par rapport au courant d'état stable correspondant au point de saut de courant précédent, ledit point de saut de courant en front montant représentant un point de saut de courant auquel la forme d'onde dudit courant de détection change d'un état stable ou état descendant à un état montant, et ledit point de saut de courant en front descendant représentant un point de saut de courant auquel la forme d'onde dudit courant de détection change d'un état stable ou état montant à un état descendant,

la sélection de points de saut de courant en front montant dont deux points de saut de courant adjacents sont tous les deux des points de saut de courant en front descendant parmi les points de saut de courant en front montant déterminés,

l'acquisition (920) des intervalles de temps entre ledit point de saut de courant et les deux points de saut de courant en front descendant adjacents pour chaque point de saut de courant en front montant sélectionné, et

la détermination (930) du nombre de motifs de forme d'onde caractéristique contenus dans les formes d'onde des courants de détection dans ledit intervalle prédéfini sur la base des deux intervalles de temps correspondants acquis de chaque point de saut de courant en front montant et de la durée d'activation et la durée de désactivation dudit condensateur.

3. Procédé selon la revendication 1, la détermination de chaque point de saut de courant dans les formes d'onde des courants de détection dans ledit intervalle prédéfini comprend :

la détermination d'un point de courant qui satisfait les deux conditions suivantes dans les formes d'onde desdits courants de détection comme étant un point de saut de courant :

$$\frac{|I(t)-I(t-T)|}{|I(t)-I(t-2T)|} > K1,$$

$$|I(t) - I(t - T)| > K2 * max\{I(t), I(t-T)\},$$

où, t est le temps sur la forme d'onde du courant de détection correspondant audit point de courant, T est la période d'échantillonnage dudit courant de détection, I(t), I(t-T) et I(t-2T) sont respectivement les valeurs de courant correspondantes à t, t-T et t-2T, K1 est un premier seuil prédéfini, K2 est un deuxième seuil prédéfini, K1 est supérieur à 1 et K2 est inférieur à 1, et la détermination du courant d'état stable correspondant à chaque point de saut de courant comprend :

la détermination du courant d'état stable correspondant audit point de saut de courant selon les valeurs de courant correspondantes à ladite pluralité de points de courant consécutifs lorsqu'une pluralité de points de courant consécutifs satisfaisant la condition suivante existe dans les formes d'onde des courants de détection entre ledit point de saut de courant et le point de saut de courant précédent et la durée est supérieure ou égale à un troisième seuil prédéfini :

$$|I(t) - I(t - T)| < K2 * max\{I(t), I(t - T)\},$$

la détermination du courant d'état stable correspondant audit point de saut de courant selon les valeurs de courant correspondantes à ladite pluralité de points de courant consécutifs comprenant de préférence :
la détermination du courant correspondant au premier point de courant de ladite pluralité de points de courant consécutifs comme étant le courant d'état stable correspondant audit point de saut de courant.

4. Procédé selon la revendication 2, la détermination (930) du nombre de motifs de forme d'onde caractéristique contenus dans les formes d'onde des courants de détection dans ledit intervalle prédéfini sur la base des deux intervalles de temps correspondants acquis de chaque point de saut de courant en front montant et de la durée d'activation et la durée de désactivation dudit condensateur comprenant :

pour chaque point de saut de courant en front montant,
l'acquisition (1010) de la valeur absolue de la différence entre la durée d'activation dudit condensateur et l'intervalle de temps entre ledit point de saut de courant en front montant et le point de saut de courant précédent afin d'obtenir une première différence,
l'acquisition (1020) de la valeur absolue de la différence entre la durée de désactivation dudit condensateur et l'intervalle de temps entre ledit point de saut de courant en front montant et le point de saut de courant suivant afin d'obtenir une deuxième différence, et
si ladite première différence et ladite deuxième différence sont toutes les deux inférieures ou égales à un seuil prédéfini, la détermination qu'un motif de forme d'onde caractéristique correspondant audit point de saut de courant en front montant existe, et
le comptage des motifs de forme d'onde caractéristique déterminés comme nombre de motifs de forme d'onde caractéristique contenus dans les formes d'onde des courants de détection dans ledit intervalle prédéfini.

5. Dispositif de détermination d'une ligne défectueuse dans un réseau de compensation de système de puissance, ledit réseau de compensation de système de puissance comprenant une pluralité de lignes (7-1, 7-2, 7-3) connectées à une barre omnibus (6), un équipement d'horloge à impulsions (4), une bobine d'extinction (52), un condensateur (51) connecté en parallèle avec ladite bobine d'extinction et un transformateur connecté avec ladite barre omnibus, ladite bobine d'extinction (52) étant connectée avec le point neutre dudit transformateur (2), et l'équipement d'horloge à impulsions (4) étant configuré pour générer des courants homopolaires sur chacune de la pluralité de lignes et pour générer des signaux d'horloge à impulsions pour périodiquement activer/désactiver ledit condensateur afin de générer périodiquement des courants de détection sur chaque ligne de ladite pluralité de lignes si un défaut de mise à la terre survient dans ledit réseau de compensation de système de puissance, la durée d'activation dudit condensateur n'étant de préférence pas égale à la durée de désactivation dudit condensateur, et ledit dispositif comprenant :

une unité d'acquisition (210), configurée pour acquérir des courants de détection sur une ligne à détecter dans ledit réseau de compensation de système de puissance,
une unité de détermination de nombre de motifs de forme d'onde caractéristique (220), configurée pour déterminer le nombre de motifs de forme d'onde caractéristique contenus dans les formes d'onde desdits courants de détection dans un intervalle prédéfini sur la base du taux de changement desdits courants de détection, ledit motif de forme d'onde caractéristique étant un motif de forme d'onde correspondant inversement à la forme d'onde de signal à une période desdits signaux d'horloge à impulsions, et
une unité de détermination de ligne défectueuse (230), configurée pour déterminer que ladite ligne à détecter est une ligne défectueuse si le nombre de motifs de forme d'onde caractéristique est supérieur ou égal à un seuil prédéfini, **caractérisé en ce que**

ladite unité de détermination de nombre de motifs de forme d'onde caractéristique (220) comprend :

un module de détermination de point de saut de courant (221), configuré pour déterminer chaque point de saut de courant dans les formes d'onde de courants de détection dans ledit intervalle prédéfini, à un point de saut de courant le courant changeant d'un état montant ou d'un état stable à un état descendant, ou d'un état descendant ou d'un état stable à un état montant,
un module de détermination de courant d'état stable (223), configuré pour déterminer le courant d'état stable correspondant à chaque point de saut de courant, et
un module de détermination de nombre de motifs de forme d'onde caractéristique (225), configuré pour déterminer le nombre de motifs de forme d'onde caractéristique contenus dans les formes d'onde desdits courants de détection dans ledit intervalle prédéfini sur la base du taux de changement du courant d'état stable correspondant à chaque point de saut de courant par rapport au courant d'état stable correspondant au point de saut de courant précédent.

6. Dispositif selon la revendication 5, ledit module de détermination de nombre de motifs de forme d'onde caractéristique (225) comprenant :

un sous-module de détermination de point de saut de courant en front montant/front descendant (2251), configuré pour déterminer les points de saut de courant en front montant et les points de saut de courant en front descendant dans lesdits points de saut de courant sur la base du taux de changement du courant d'état stable correspondant à chaque point de saut de courant par rapport au courant d'état stable correspondant au point de saut de courant précédent, ledit point de saut de courant en front montant représentant un point de saut de courant auquel la forme d'onde dudit courant de détection change d'un état stable ou état descendant à un état montant, et ledit point de saut de courant en front descendant représentant un point de saut de courant auquel la forme d'onde dudit courant de détection change d'un état stable ou état montant à un état descendant,
un sous-module de sélection (2257), configuré pour sélectionner des points de saut de courant en front montant dont deux points de saut de courant adjacents sont tous les deux des points de saut de courant en front descendant parmi les points de saut de courant en front montant déterminés,
un sous-module d'acquisition d'intervalle de temps (2253), configuré pour acquérir les intervalles de temps entre ledit point de saut de courant et les deux points de saut de courant en front descendant adjacents pour chaque point de saut de courant en front montant sélectionné, et
un sous-module de détermination de nombre de motifs de forme d'onde caractéristique (2255), configuré pour déterminer le nombre de motifs de forme d'onde caractéristique contenus dans les formes d'onde des courants de détection dans ledit intervalle prédéfini sur la base des deux intervalles de temps correspondants acquis de chaque point de saut de courant en front montant et de la durée d'activation et la durée de désactivation dudit condensateur.

7. Dispositif selon la revendication 5, ledit module de détermination de point de saut de courant (221) étant configuré pour

déterminer un point de courant qui satisfait les deux conditions suivantes dans les formes d'onde desdits courants de détection comme étant un point de saut de courant :

$$\frac{|I(t)-I(t-T)|}{|I(t)-I(t-2T)|} > K1,$$

$$|I(t) - I(t - T)| > K2 * max\{I(t), I(t - T)\},$$

où, t est le temps sur la forme d'onde du courant de détection correspondant audit point de courant, T est la période d'échantillonnage dudit courant de détection, I(t), I(t-T) et I(t-2T) sont respectivement les valeurs de courant correspondantes à t, t-T et t-2T, K1 est un premier seuil prédéfini, K2 est un deuxième seuil prédéfini, K1 est supérieur à 1 et K2 est inférieur à 1,
ledit module de détermination de courant d'état stable (223) étant configuré pour
déterminer le courant d'état stable correspondant audit point de saut de courant selon les valeurs de courant correspondantes à ladite pluralité de points de courant consécutifs lorsqu'une pluralité de points de courant consécutifs satisfaisant la condition suivante existe dans les formes d'onde des courants de détection entre ledit point de saut de courant et le point de saut de courant précédent et la durée est supérieure ou égale à un troisième seuil prédéfini :

$$|I(t) - I(t - T)| < K2 * max\{I(t), I(t - T)\}.$$

**8.** Dispositif selon la revendication 7, ledit module de détermination de courant d'état stable (223) étant configuré pour déterminer le courant correspondant au premier point de courant de ladite pluralité de points de courant consécutifs comme étant le courant d'état stable correspondant audit point de saut de courant.

**9.** Dispositif selon la revendication 6, ledit sous-module de détermination de nombre de motifs de forme d'onde caractéristique (2255) étant configuré pour

pour chaque point de saut de courant en front montant,
acquérir la valeur absolue de la différence entre la durée d'activation dudit condensateur et l'intervalle de temps entre ledit point de saut de courant en front montant et le point de saut de courant précédent afin d'obtenir une première différence,
acquérir la valeur absolue de la différence entre la durée de désactivation dudit condensateur et l'intervalle de temps entre ledit point de saut de courant en front montant et le point de saut de courant suivant afin d'obtenir une deuxième différence, et
si ladite première différence et ladite deuxième différence sont toutes les deux inférieures ou égales à un seuil prédéfini, déterminer qu'un motif de forme d'onde caractéristique correspondant audit point de saut de courant en front montant existe, et
compter les motifs de forme d'onde caractéristique déterminés comme nombre de motifs de forme d'onde caractéristique contenus dans les formes d'onde des courants de détection dans ledit intervalle prédéfini.

**10.** Dispositif informatique, comprenant :

des processeurs, et
une mémoire couplée auxdits processeurs, configurée pour stocker des instructions, lorsque lesdites instructions sont exécutées par lesdits un ou plusieurs processeurs, lesdits processeurs étant amenés à exécuter le procédé selon l'une quelconque des revendications 1 à 4.

**11.** Support de stockage lisible par machine, stockant des instruction exécutables, lorsque lesdites instructions sont exécutées, ladite machine étant amenée à exécuter le procédé selon l'une quelconque des revendications 1 à 4.

Figure 1

Figure 2

10

100

200

Figure 3

Figure 4

Figure 5

Figure 6

Figure 7

Figure 8

Figure 9

Figure 10

1100

1110

1120

Figure 11

**EP 3 544 135 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201810237112
- WO 2017200469 A1